# EUROPEAN PATENT APPLICATION

(11) **EP 4 815 413 A1**
(43) Date of publication of application: **30.09.2026**
(21) Application number: 24905667.2
(22) Date of filing: 05.09.2024
(51) Int. Cl.: H04M 1/02, F16C 11/04

(54) **ROTATING MECHANISM AND FOLDABLE ELECTRONIC DEVICE**

(30) Priority: 21.12.2023 CN 202311777126
(71) Applicant: Huawei Technologies Co., Ltd., Shenzhen, Guangdong 518129 (CN)
(72) Inventor: SHEN, Hewen, Shenzhen, Guangdong 518129 (CN); ZHONG, Ding, Shenzhen, Guangdong 518129 (CN); WU, Wenwen, Shenzhen, Guangdong 518129 (CN); YAN, Zhiguo, Shenzhen, Guangdong 518129 (CN); HU, Yuehua, Shenzhen, Guangdong 518129 (CN); LI, Jingzong, Shenzhen, Guangdong 518129 (CN)
(74) Representative: Thun, Clemens
(86) International application number: PCT/CN2024/117229
(87) International publication number: WO 2025/130175

(57) **Abstract**

Embodiments of this application provide a rotating mechanism and a foldable electronic device, to improve relatively poor reliability of a flexible display. The rotating mechanism includes a main shaft, two hinge assemblies, and a support plate. A first hinge assembly is rotatably connected to the main shaft, a second hinge assembly is rotatably connected to the main shaft, and the support plate includes a first sub-portion, a second sub-portion, a third sub-portion, and a fourth sub-portion. When the two hinge assemblies are in an unfolded state, the four sub-portions are sequentially arranged in a second direction, and jointly form a support plane. In a process in which the rotating mechanism switches from the unfolded state to a folded state, the four sub-portions all rotate relative to the main shaft, and none of the four sub-portions undergoes bending. When the two hinge assemblies are in the folded state, a flexible display may be bent into a teardrop shape or an approximate teardrop shape in screen accommodating space enclosed by the four sub-portions and the main shaft, to avoid excessive extrusion on the flexible display. A distance between a first end of the second sub-portion and a first end of the third sub-portion increases. This helps further increase screen accommodating space.

## Description

This application claims priority to Chinese Patent Application No. 202311777126.5, filed with the China National Intellectual Property Administration on December 21, 2023 and entitled "ROTATING MECHANISM AND FOLDABLE ELECTRONIC DEVICE", which is incorporated herein by reference in its entirety.

### TECHNICAL FIELD

Embodiments of this application relate to the field of foldable electronic product technologies, and in particular, to a rotating mechanism and a foldable electronic device.

### BACKGROUND

With continuous development of display technologies, foldable display terminals gradually become a development trend of future mobile electronic products. The foldable electronic device can have a large display area in an unfolded state, thereby improving a viewing effect. The foldable electronic device can have a small size in a folded state, and therefore is convenient for a user to carry.

The foldable electronic device includes at least a flexible display and a housing apparatus. The housing apparatus includes two mechanical parts configured to carry the flexible display and a rotating mechanism. The two mechanical parts are connected to two sides of the rotating mechanism. In an actual use process, the rotating mechanism drives the two mechanical parts to rotate, so that the foldable electronic device is folded or unfolded. In a conventional electronic device with an inward-folding screen, when the electronic device is folded, a flexible display is folded on an inner side of a housing apparatus, and a bent part of the flexible display is prone to damage due to excessive extrusion by the housing apparatus. Consequently, reliability of the flexible display is poor.

### SUMMARY

Embodiments of this application provide a rotating mechanism and a foldable electronic device, to resolve a problem that reliability of a flexible display is poor.

To achieve the foregoing objective, embodiments of this application provide the following solutions.

According to an aspect, a rotating mechanism is provided, including a main shaft, two hinge assemblies, and a support plate. The main shaft extends in a first direction. The two hinge assemblies include a first hinge assembly and a second hinge assembly, the first hinge assembly is rotatably connected to the main shaft, the second hinge assembly is rotatably connected to the main shaft, and rotation axes of the two hinge assemblies relative to the main shaft are both parallel to the first direction and do not coincide. The support plate includes four sub-portions, and the four sub-portions include a first sub-portion, a second sub-portion, a third sub-portion, and a fourth sub-portion. The first sub-portion is connected to the first hinge assembly, the second sub-portion is connected to the first hinge assembly, the third sub-portion is connected to the second hinge assembly, and the fourth sub-portion is connected to the second hinge assembly.

When the two hinge assemblies are in an unfolded state, the first sub-portion, the second sub-portion, the third sub-portion, and the fourth sub-portion are sequentially arranged in a second direction; the first sub-portion, the second sub-portion, the third sub-portion, and the fourth sub-portion jointly form a support plane; in the second direction, a second end of the first sub-portion, a first end of the first sub-portion, a second end of the second sub-portion, a first end of the second sub-portion, a first end of the third sub-portion, a second end of the third sub-portion, a first end of the fourth sub-portion, and a second end of the fourth sub-portion are sequentially arranged; a distance between the first end of the second sub-portion and the first end of the third sub-portion in the second direction is a first distance; and the second direction is perpendicular to the first direction. The support plane may be used to support a flexible display, to improve flatness of the flexible display in the unfolded state. Herein, the "support plane" may be understood as a horizontal plane or an approximate horizontal plane. The horizontal plane may be a horizontal surface parallel to the first direction and the second direction, the approximate horizontal plane may be a surface with a slight fluctuation, and an acceptable deviation range of the approximate horizontal plane may be, for example, a deviation within 5%.

In a process in which the rotating mechanism switches from the unfolded state to a folded state, the first sub-portion, the second sub-portion, the third sub-portion, and the fourth sub-portion rotate relative to the main shaft, and none of the four sub-portions of the support plate undergoes bending. Herein, "none undergoes bending" may be understood as meaning that none of the four sub-portions of the support plate is elastically deformed from a macro perspective. For example, the first sub-portion, the second sub-portion, the third sub-portion, and the fourth sub-portion may all be made of rigid materials, and in the process in which the rotating mechanism switches from the unfolded state to the folded state, none of structural shapes of the four sub-portions of the support plate from a macro perspective changes.

When the two hinge assemblies are in the folded state, a distance between the first end of the first sub-portion and the first end of the fourth sub-portion is greater than a distance between the second end of the first sub-portion and the second end of the fourth sub-portion in the second direction, a distance between the first end of the second sub-portion and the first end of the third sub-portion is less than a distance between the second end of the second sub-portion and the second end of the third sub-portion in the second direction, the distance between the first end of the second sub-portion and the first end of the third sub-portion in the second direction is a second distance, and the second distance is greater than the first distance. Through the foregoing arrangement, the flexible display may be bent into a teardrop shape or an approximate teardrop shape in screen accommodating space enclosed by the first sub-portion, the second sub-portion, the third sub-portion, the fourth sub-portion, and the main shaft, to avoid excessive extrusion on the flexible display, thereby reducing stress of the flexible display and improving reliability of the flexible display. In addition, the second distance is greater than the first distance. When the two hinge assemblies are in the unfolded state, the distance between the first end of the second sub-portion and the first end of the third sub-portion decreases. This helps improve a support effect of the flexible display. When the two hinge assemblies are in the folded state, the distance between the first end of the second sub-portion and the first end of the third sub-portion increases. This helps further enlarge the screen accommodating space enclosed by the first sub-portion, the second sub-portion, the third sub-portion, the fourth sub-portion, and the main shaft, thereby further improving reliability of the flexible display.

In some implementations, when the two hinge assemblies are in the folded state, in a direction close to the main shaft, a distance between the first sub-portion and the fourth sub-portion in the second direction gradually increases. Through the foregoing arrangement, flatness of the support plane including the first sub-portion and the fourth sub-portion is ensured, thereby ensuring a support effect of the first sub-portion and the fourth sub-portion. In addition, this helps improve regularity of the first sub-portion and the fourth sub-portion, and improve preparation efficiency of the first sub-portion and the fourth sub-portion. Alternatively, a distance between the first sub-portion and the fourth sub-portion in the second direction first decreases and then increases. Through the foregoing arrangement, when the two hinge assemblies are in the folded state, interference between the flexible display and the second end of the first sub-portion and the second end of the fourth sub-portion can be avoided, thereby helping improve reliability of the flexible display.

In some implementations, when the two hinge assemblies are in the folded state, in a direction close to the main shaft, a distance between the second sub-portion and the third sub-portion in the second direction gradually decreases. Through the foregoing arrangement, flatness of the support plane including the second sub-portion and the third sub-portion is ensured, thereby ensuring a support effect of the second sub-portion and the third sub-portion. In addition, this helps improve regularity of the second sub-portion and the third sub-portion, and improve preparation efficiency of the second sub-portion and the third sub-portion.

In some implementations, the first hinge assembly includes a first connecting rod, a second connecting rod, and a support, a first end of the first connecting rod is rotatably connected to the main shaft, a second end of the first connecting rod is rotatably connected to a first end of the second connecting rod, a second end of the second connecting rod is rotatably connected to the support, a rotation axis of the support relative to the second connecting rod is parallel to the first direction, a rotation axis of the second connecting rod relative to the first connecting rod is parallel to the first direction, and a rotation axis of the first connecting rod relative to the main shaft is parallel to the first direction; and that the first sub-portion is connected to the first hinge assembly, and the second sub-portion is connected to the first hinge assembly includes: the first sub-portion is connected to the second connecting rod, and the second sub-portion is connected to the first connecting rod. Through the foregoing arrangement, when a first mechanical part drives the support to rotate, the support can drive the second connecting rod to rotate relative to the main shaft, so that the first sub-portion can rotate relative to the main shaft, and the second connecting rod can drive the first connecting rod to rotate relative to the main shaft, so that the second sub-portion can rotate relative to the main shaft.

In some implementations, that the first end of the first connecting rod is rotatably connected to the main shaft includes: the first end of the first connecting rod is rotatably connected to the main shaft through a first arc-shaped sliding block and a first arc-shaped sliding slot. The first end of the first connecting rod includes the first arc-shaped sliding block, and the main shaft includes the first arc-shaped sliding slot; or the first end of the first connecting rod includes the first arc-shaped sliding slot, and the main shaft includes the first arc-shaped sliding block. Through the foregoing arrangement, the first connecting rod can be mounted inside the main shaft, and the first connecting rod can be rotatably connected to the main shaft in a connection manner with a virtual shaft.

In some implementations, the first end of the second connecting rod is connected to the second end of the first connecting rod through a pin shaft, and that the second end of the second connecting rod is rotatably connected to the support includes: the second end of the second connecting rod is rotatably connected to the support through a second arc-shaped sliding block and a second arc-shaped sliding slot. The second end of the second connecting rod includes the second arc-shaped sliding block, and the support includes the second arc-shaped sliding slot; or the second end of the second connecting rod includes the second arc-shaped sliding slot, and the support includes the second arc-shaped sliding block. Through the foregoing arrangement, the first end of the second connecting rod is rotatably connected to the second end of the first connecting rod in a rotation manner with a physical shaft. This helps improve rotation precision and connection reliability between the second connecting rod and the first connecting rod. The second connecting rod is rotatably connected to the support in a connection manner with a virtual shaft. Further, the second connecting rod is connected to the support by using the virtual shaft, so that a rotation axis of the second connecting rod relative to the support may be closer to the flexible display, thereby avoiding pulling the flexible display in a rotation process of the hinge assembly. This helps improve reliability of the flexible display.

In some implementations, the first hinge assembly further includes a third connecting rod, a first end of the third connecting rod is rotatably connected to the first connecting rod, and a second end of the third connecting rod is rotatably connected to the support; a rotation axis of the third connecting rod relative to the first connecting rod is a first axis, the first axis is parallel to the first direction, a rotation axis of the second connecting rod relative to the first connecting rod is a second axis, and when the two hinge assemblies are in the unfolded state, the second axis is farther away from the main shaft in a third direction compared with the first axis; and a rotation axis of the third connecting rod relative to the support is a third axis, the third axis is parallel to the first direction, a rotation axis of the second connecting rod relative to the support is a fourth axis, and when the two hinge assemblies are in the unfolded state, the fourth axis is farther away from the main shaft in the third direction relative to the third axis. The third direction is perpendicular to the first direction and the second direction. Through the foregoing arrangement, the first connecting rod, the second connecting rod, the third connecting rod, and the support may jointly form a four-connecting-rod mechanism. The four-connecting-rod mechanism may play a main motion effect, and may drive another mechanism connected between the support and the main shaft to move.

In some implementations, the second end of the third connecting rod is connected to the support through a pin shaft, the first connecting rod includes a third arc-shaped sliding slot, and that the first end of the third connecting rod is rotatably connected to the first connecting rod includes: the first end of the third connecting rod is rotatably connected to the first connecting rod through a third arc-shaped sliding block and the third arc-shaped sliding slot. The first end of the third connecting rod includes the third arc-shaped sliding block, and the first connecting rod includes the third arc-shaped sliding slot; or the first end of the third connecting rod includes the third arc-shaped sliding slot, and the first connecting rod includes the third arc-shaped sliding block. Through the foregoing arrangement, the third connecting rod is rotatably connected to the first connecting rod in a connection manner with a virtual shaft, and the third connecting rod is rotatably connected to the support in a rotation manner with a physical shaft. It may be understood that, because the rotation manner with the virtual shaft needs to be provided with an arc-shaped sliding slot and an arc-shaped sliding block that fit with each other, large space needs to be occupied. The third connecting rod is rotatably connected to the support in a connection manner with a physical shaft. This helps reduce a size of the support and improve reliability of connection between the third connecting rod and the support.

In some implementations, the first hinge assembly further includes a fourth connecting rod, a first end of the fourth connecting rod is rotatably connected to the main shaft, a second end of the fourth connecting rod is rotatably connected to the support, and both a rotation axis of the support relative to the fourth connecting rod and a rotation axis of the fourth connecting rod relative to the main shaft are parallel to the first direction. Disposing the fourth connecting rod helps further improve reliability of connection between the support and the main shaft.

In some implementations, the second end of the fourth connecting rod is connected to the support through a pin shaft, and that the first end of the fourth connecting rod is rotatably connected to the main shaft includes: the first end of the fourth connecting rod is rotatably connected to the main shaft through a fourth arc-shaped sliding block and a fourth arc-shaped sliding slot. The first end of the fourth connecting rod includes the fourth arc-shaped sliding block, and the main shaft further includes the fourth arc-shaped sliding slot; or the first end of the fourth connecting rod includes the fourth arc-shaped sliding slot, and the main shaft further includes the fourth arc-shaped sliding block. Through the foregoing arrangement, when the fourth body can be rotatably connected to the support in a connection manner with a physical shaft, and the fourth connecting rod is rotatably connected to the main shaft in a connection manner with a virtual shaft, the fourth connecting rod can rotate relative to the main shaft while the fourth arc-shaped sliding block slides along the fourth arc-shaped sliding slot.

In some implementations, the first hinge assembly further includes a swing rod, a first end of the swing rod is rotatably connected to the main shaft, a rotation axis of the swing rod relative to the main shaft is parallel to the first direction, a second end of the swing rod is slidably connected to the support, and a sliding direction of the swing rod relative to the support is not parallel to an extension direction of the support; and when the two hinge assemblies rotate from the unfolded state to the folded state, the support slides relative to the swing rod in a direction away from the main shaft; and when the two hinge assemblies rotate from the folded state to the unfolded state, the support slides relative to the swing rod in a direction close to the main shaft. The foregoing arrangement helps adjust a length between two supports. In a process of folding or unfolding the two hinge assemblies, this helps ensure that a length of the flexible display does not change, and improve a phenomenon of extruding or stretching the flexible display by the rotating mechanism.

In some implementations, the first end of the swing rod includes a swing rod sliding block, the second end of the swing rod is rotatably connected to the main shaft through a pin shaft, the support includes a support sliding slot, and the swing rod sliding block is slidably connected to the support sliding slot. Through the foregoing arrangement, the swing rod and the main shaft may be rotatably connected in a connection manner with a physical shaft. This helps improve connection reliability and rotation precision between the swing rod and the main shaft.

In some implementations, the support plate further includes a bendable portion, and the bendable portion is connected between the second sub-portion and the first sub-portion. When the two hinge assemblies are in the unfolded state, the bendable portion is flattened; and when the two hinge assemblies are in the folded state, the bendable portion is bent, and a bending angle is formed between the first sub-portion and the second sub-portion. Through the foregoing arrangement, the bendable portion may fill a gap between the second sub-portion and the first sub-portion. When the two hinge assemblies are in the unfolded state, this helps further improve an effect of supporting the flexible display by the support plate.

In some implementations, the bendable portion, the second sub-portion, and the first sub-portion are of an integrated structure. The foregoing arrangement helps improve connection reliability of the support plate.

In some implementations, the bendable portion has a plurality of through holes that penetrate the bendable portion. The foregoing arrangement helps reduce rigidity of the bendable portion, and reduce an elastic force of the bendable portion on the flexible display when the bendable portion is bent, thereby improving a bending hand feeling of the support plate.

In some implementations, a thickness of the bendable portion is less than a thickness of the first sub-portion, and the thickness of the bendable portion is less than a thickness of the second sub-portion. The foregoing arrangement helps reduce rigidity of the bendable portion, and reduce an elastic force of the bendable portion on the flexible display when the bendable portion is bent, thereby improving a bending hand feeling of the support plate.

In some implementations, the support plate further includes a flexible layer, the flexible layer is connected to a same side of the second sub-portion and the first sub-portion, and the flexible layer located between the second sub-portion and the first sub-portion is the bendable portion. Through the foregoing arrangement, when the two hinge assemblies are in the unfolded state, the flexible layer between the second sub-portion and the first sub-portion is flattened. This helps further improve an effect of supporting the flexible display by the support plate. When the two hinge assemblies are in the folded state, the flexible layer between the second sub-portion and the first sub-portion is bent.

In some implementations, in a direction perpendicular to the support plane, the first sub-portion and the main shaft at least partially overlap, and the second sub-portion and the main shaft at least partially overlap. The foregoing arrangement helps reduce a dimension of the rotating mechanism in the second direction, thereby facilitating a thinner and lighter a foldable electronic device.

According to another aspect, a foldable electronic device is provided, including a flexible display, a first mechanical part, a second mechanical part, and the rotating mechanism in any one of the foregoing embodiments. The first mechanical part and the second mechanical part are connected to two sides of the rotating mechanism, and the flexible display is located on a same side of the first mechanical part and the second mechanical part, and is connected to the first mechanical part and the second mechanical part. When the foldable electronic device is in an unfolded state, a support plane of the rotating mechanism is used to support the flexible display. When the foldable electronic device is in a folded state, a first sub-portion of the rotating mechanism, a second sub-portion of the rotating mechanism, a third sub-portion of the rotating mechanism, a fourth sub-portion of the rotating mechanism, and a main shaft of the rotating mechanism jointly enclose screen accommodating space, and a part of the flexible display is located in the screen accommodating space. The foldable electronic device provided in embodiments of this application includes the foregoing rotating mechanism, and therefore has all the foregoing beneficial effects. Details are not described herein again.

In some implementations, at least one of the first sub-portion, the second sub-portion, the third sub-portion, and the fourth sub-portion is connected to the flexible display. Through the foregoing arrangement, the flexible display can be fastened to a support plate.

### BRIEF DESCRIPTION OF DRAWINGS

FIG. 1 is a diagram of a structure of a foldable electronic device according to an embodiment of this application;
FIG. 2 is a diagram of a structure of a foldable electronic device in an unfolded state according to an embodiment of this application;
FIG. 3 is a local exploded view of the foldable electronic device in FIG. 2;
FIG. 4 is a sectional view of the foldable electronic device in FIG. 2 in a folded state along an A-A section line;
FIG. 5 is a sectional view of the foldable electronic device in FIG. 2 in an unfolded state along a B-B section line;
FIG. 6 is a sectional view of the foldable electronic device in FIG. 2 in a folded state along a C-C section line;
FIG. 7 is an exploded view of a structure of a rotating mechanism according to an embodiment of this application;
FIG. 8 is a diagram of a structure of a rotating module according to an embodiment of this application;
FIG. 9 is an exploded view of a structure of a rotating module according to an embodiment of this application;
FIG. 10 is an exploded view of a structure of another rotating module according to an embodiment of this application;
FIG. 11a is a diagram of a structure of a main shaft according to an embodiment of this application;
FIG. 11b is a diagram of a structure of a support fitting portion in a main shaft according to an embodiment of this application;
FIG. 12A and FIG. 12B are diagrams of a structure of a first connecting rod according to an embodiment of this application;
FIG. 13 is a diagram of a structure of a second connecting rod according to an embodiment of this application;
FIG. 14A and FIG. 14B are diagrams of a structure of a support according to an embodiment of this application;
FIG. 15 is a diagram of a structure of a third connecting rod according to an embodiment of this application;
FIG. 16 is a local sectional view of a rotating mechanism in an unfolded state according to an embodiment of this application;
FIG. 17 is a local sectional view of a rotating mechanism in a folded state according to an embodiment of this application;
FIG. 18 is an exploded view of a structure of another rotating module according to an embodiment of this application;
FIG. 19 is a diagram of a structure of a fourth connecting rod according to an embodiment of this application;
FIG. 20 is a diagram of a structure of a support fitting portion in another main shaft according to an embodiment of this application;
FIG. 21 is a diagram of a structure of a swing rod according to an embodiment of this application;
FIG. 22 is a local sectional view of another rotating mechanism in an unfolded state according to an embodiment of this application;
FIG. 23 is a local sectional view of another rotating mechanism in a folded state according to an embodiment of this application;
FIG. 24 is a principle diagram of main motion of another rotating mechanism according to an embodiment of this application;
FIG. 25 is a local exploded view of another rotating mechanism according to an embodiment of this application;
FIG. 26A and FIG. 26B are local diagrams of a structure of another second part according to an embodiment of this application;
FIG. 27 is a sectional view of the rotating mechanism in FIG. 25 in an unfolded state along an F-F section line;
FIG. 28 is a sectional view of the rotating mechanism in FIG. 25 in a folded state along an F-F section line;
FIG. 29 is a diagram of a structure of another support plate according to an embodiment of this application;
FIG. 30 is a local enlarged view of a position N of the support plate in FIG. 29;
FIG. 31 is a diagram of a structure of another support plate according to an embodiment of this application;
FIG. 32 is a sectional view of a support plate in FIG. 31 along a G-G section line;
FIG. 33 is a sectional view of another support plate in FIG. 31 along a G-G section line;
FIG. 34 is an exploded view of a structure of a first structural portion according to an embodiment of this application;
FIG. 35 is a diagram of a structure of a first fitting portion of a main shaft according to an embodiment of this application;
FIG. 36 is a diagram of a structure of a damping sliding block according to an embodiment of this application;
FIG. 37 is an exploded view of a structure of a second structural portion according to an embodiment of this application;
FIG. 38 is a diagram of a structure of a second fitting portion of a main shaft according to an embodiment of this application;
FIG. 39 is a diagram of a structure of a first synchronization sliding block according to an embodiment of this application; and
FIG. 40 is a diagram of a structure of a second synchronization sliding block according to an embodiment of this application.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

The following terms "first", "second", and the like are merely used for ease of description, but should not be understood as indicating or implying relative importance or implying a quantity of indicated technical features. Therefore, a feature limited by "first", "second", or the like may explicitly or implicitly include one or more features. In the descriptions of this application, unless otherwise stated, "a plurality of" means two or more.

In embodiments of this application, words such as "example" or "for example" are used to represent giving examples, illustrations, or descriptions. Any embodiment or design solution described as "example" or "for example" in embodiments of this application should not be construed as being more preferred or advantageous than other embodiments or design solutions. Specifically, the words such as "example" or "for example" are used to present related concepts in a specific manner.

In embodiments of this application, for example, up, down, left, right, front, and rear are relative direction indications used to explain structures and movement of different parts in this application. These indications are appropriate when the parts are in positions shown in the figure. However, if descriptions of the positions of the parts change, these direction indications correspondingly change.

Embodiments of this application provide a foldable electronic device. The foldable electronic device may be a terminal product such as a mobile phone (mobile phone), a tablet computer (pad), a television, or an intelligent wearable product (for example, a smartwatch or a smart band).

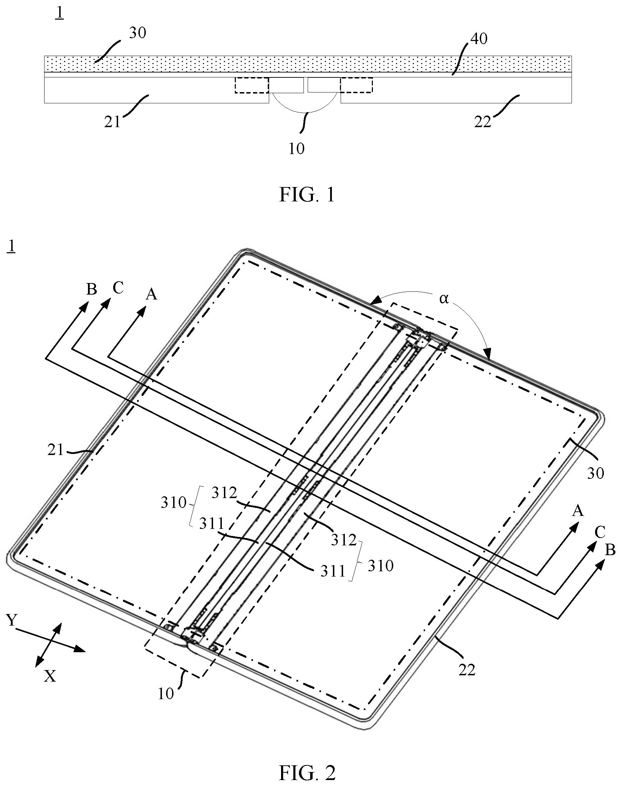

The following facilitates understanding of a foldable electronic device 1 provided in an embodiment of this application. FIG. 1 is a diagram of a structure of a foldable electronic device 1 according to an embodiment of this application. With reference to FIG. 1, the following describes the foldable electronic device 1 as follows:

As shown in FIG. 1, the foldable electronic device 1 includes a flexible display 30. The flexible display 30 may be an active-matrix organic light-emitting diode (active-matrix organic light-emitting diode, AMOLED) display.

Because the AMOLED display is a self-luminous display, a backlight module (backlight module, BLM) does not need to be disposed. Therefore, when a substrate of the AMOLED display is made of a flexible resin material such as polyethylene terephthalate (polyethylene terephthalate, PET), the AMOLED display can have a bendable characteristic.

In addition, as shown in FIG. 1, the foldable electronic device 1 further includes a rotating mechanism 10, a first mechanical part 21, and a second mechanical part 22 that are configured to carry the flexible display 30. The rotating mechanism 10 is connected between the first mechanical part 21 and the second mechanical part 22. The first mechanical part 21 and the second mechanical part 22 are configured to: carry the flexible display 30, to keep the flexible display 30 flat to the greatest extent during use; and protect a non-display surface of the flexible display 30. The first mechanical part 21 and the second mechanical part 22 may rotate relative to the rotating mechanism 10. In this embodiment of this application, only partial structures of the first mechanical part 21 and the second mechanical part 22 are briefly described as an example, and simplified illustrations are provided in the accompanying drawings. Specific structures of the first mechanical part 21 and the second mechanical part 22 are not strictly limited in this embodiment of this application.

The first mechanical part 21 and the second mechanical part 22 each may include a middle frame structure, configured to mount and fasten other components of the foldable electronic device 1, for example, a camera, a headset, an earpiece, a button, and a battery. Other electronic elements disposed on the first mechanical part 21 and the second mechanical part 22 are not limited in this embodiment of this application. The first mechanical part 21 and the second mechanical part 22 each may further include a decorative cover plate, configured to protect a component inside the middle frame structure, and also configured to present a partial appearance of the foldable electronic device 1.

For example, a part of the flexible display 30 may be fastened to the first mechanical part 21 by using an adhesive layer 40, a part of the flexible display 30 may be fastened to the second mechanical part 22 by using the adhesive layer 40, and a part of the flexible display 30 may be fastened to the rotating mechanism 10. The adhesive layer 40 may be a thin film layer formed after an adhesive is applied. A specific form of the adhesive layer 40 is not limited in this embodiment of this application. For example, the adhesive layer 40 may be an intermittent thin film layer, or the adhesive layer 40 may be an integral thin film layer. In addition, other electronic elements may be further disposed on the first mechanical part 21 and the second mechanical part 22.

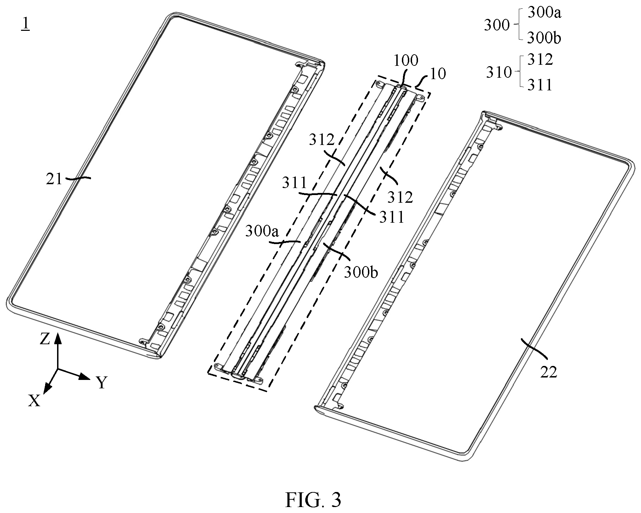

FIG. 2 is a diagram of a structure of the foldable electronic device 1 in an unfolded state according to an embodiment of this application. A dash-dot line box in FIG. 2 is a placement position of the flexible display 30 in the unfolded state. FIG. 3 is an exploded view of a local structure of the foldable electronic device 1 in FIG. 2. Refer to FIG. 2 and FIG. 3. The rotating mechanism 10 includes a main shaft 100 and two hinge assemblies 300. For ease of description, a first direction X is defined as an extension direction of the main shaft 100 below, a second direction Y is perpendicular to the first direction X, and a third direction Z is perpendicular to a plane on which the first direction X and the second direction Y are located. The two hinge assemblies 300 are arranged in the second direction Y, and the two hinge assemblies 300 are rotatably connected to the main shaft 100. Rotation axes of the two hinge assemblies 300 relative to the main shaft 100 are both parallel to the first direction X and do not coincide.

For example, one end of one hinge assembly 300 is rotatably connected to the main shaft 100, and the other end of the one hinge assembly 300 is connected to the first mechanical part 21. One end of the other hinge assembly 300 is rotatably connected to the main shaft 100, and the other end of the other hinge assembly 300 is connected to the second mechanical part 22. For example, the two hinge assemblies 300 may include a first hinge assembly 300a and a second hinge assembly 300b. One end of the first hinge assembly 300a is rotatably connected to the main shaft 100, and the other end of the first hinge assembly 300a is connected to the first mechanical part 21. One end of the second hinge assembly 300b is rotatably connected to the main shaft 100, and the other end of the second hinge assembly 300b is connected to the second mechanical part 22. Through the foregoing arrangement, the first mechanical part 21 can drive the first hinge assembly 300a to rotate relative to the main shaft 100, and the second mechanical part 22 can drive the second hinge assembly 300b to rotate relative to the main shaft 100, to fold or unfold the foldable electronic device 1.

As shown in FIG. 2, when the first mechanical part 21 and the second mechanical part 22 are in the unfolded state, an included angle between the first mechanical part 21 and the second mechanical part 22 may be approximately 180° (it may be understood that a small deviation is allowed for the included angle between the first mechanical part 21 and the second mechanical part 22, for example, the included angle may be 165°, 177°, or 185°). In this case, the two hinge assemblies 300 are in the unfolded state, and the flexible display 30 is also in the unfolded state, that is, the foldable electronic device 1 is in the unfolded state.

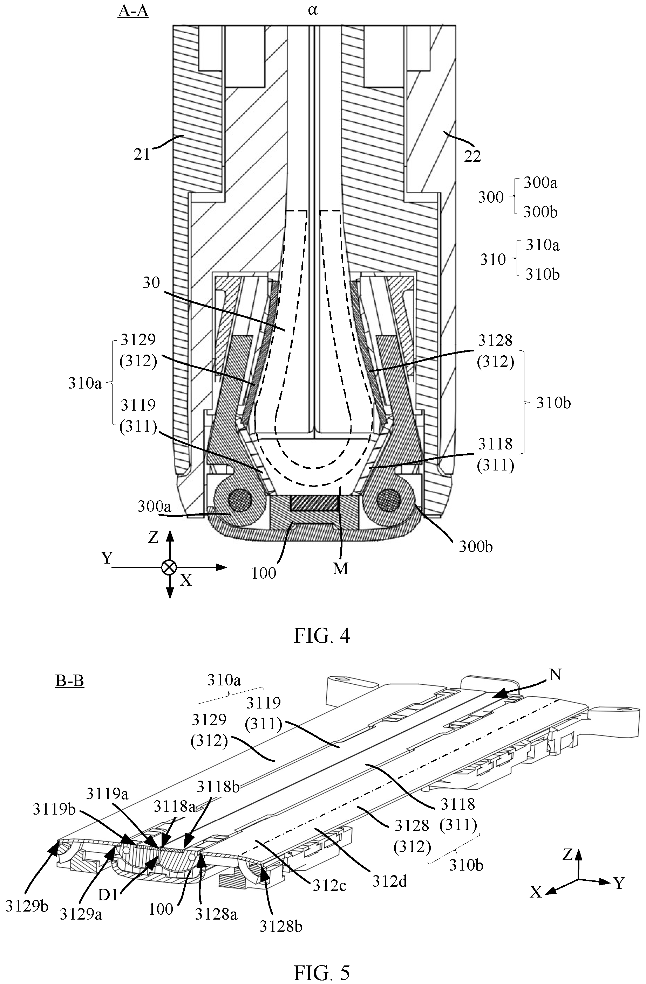

FIG. 4 is a sectional view of the foldable electronic device 1 in FIG. 2 in a folded state along an A-A section line, where a dashed-line box in FIG. 4 is a placement position of the flexible display 30 in the folded state. As shown in FIG. 4, when the first mechanical part 21 and the second mechanical part 22 are in the folded state, an included angle between the first mechanical part 21 and the second mechanical part 22 may be approximately 0° (it may be understood that a small deviation is allowed for the included angle between the first mechanical part 21 and the second mechanical part 22, for example, the included angle may be 1°, 3°, or 5°). In this case, the two hinge assemblies 300 are in the folded state, and the flexible display 30 is also in the folded state, that is, the foldable electronic device 1 is in the folded state. In some embodiments, when the first mechanical part 21 and the second mechanical part 22 are in the folded state, the first mechanical part 21 and the second mechanical part 22 may be in contact with each other to implement positioning. In some other embodiments, when the first mechanical part 21 and the second mechanical part 22 are in the folded state, the first mechanical part 21 and the second mechanical part 22 may be close to each other, and there is a small gap between the first mechanical part 21 and the second mechanical part 22. This is not specifically limited in this embodiment of this application.

Still refer to FIG. 2, FIG. 3, and FIG. 4. The rotating mechanism 10 includes a support plate 310, and the support plate 310 is configured to support the flexible display 30. In embodiments of some related technologies, there may be two support plates 310. When the first mechanical part 21 and the second mechanical part 22 are in the unfolded state, the two support plates 310 are located on two sides of the main shaft 100, and the two support plates 310 and the main shaft 100 jointly provide a good support environment for the flexible display 30. When the first mechanical part 21 and the second mechanical part 22 are in the folded state, the two support plates 310 are located on a same side of the main shaft 100, and the two support plates 310 excessively extrude the flexible display 30. This may cause damage to the flexible display 30, and further reduce reliability of the flexible display 30.

In view of this, with reference to FIG. 4, in the hinge assembly 300 provided in this embodiment of this application, the support plate 310 may include a first support plate 310a and a second support plate 310b. The first support plate 310a may include a first part 311 and a second part 312, and the second support plate 310b may also include a first part 311 and a second part 312. In some embodiments, a first part 311 and a second part 312 in a same support plate 310 may be two structures that are independent of each other. Alternatively, in some other embodiments, a first part 311 and a second part 312 in a same support plate 310 may be of an integrated structure. For example, the first part 311 and the second part 312 may be approximately strip-shaped flat plates, and extension directions of the strip-shaped flat plates may be parallel to the first direction X.

In some embodiments, the support plate 310 may include four sub-portions, and the four sub-portions may include a first sub-portion 3129, a second sub-portion 3119, a third sub-portion 3118, and a fourth sub-portion 3128. The first sub-portion 3129 and the second sub-portion 3119 jointly form the first support plate 310a, the first sub-portion 3129 may be the second part 312 of the first support plate 310a, and the second sub-portion 3119 is the first part 311 of the first support plate 310a. In addition, the first sub-portion 3129 is connected to the first hinge assembly 300a, and the second sub-portion 3119 is connected to the first hinge assembly 300a. The third sub-portion 3118 and the fourth sub-portion 3128 jointly form the second support plate 310b, the third sub-portion 3118 is the first part 311 of the second support plate 310b, and the fourth sub-portion 3128 is the second part 312 of the second support plate 310b. In addition, the third sub-portion 3118 is connected to the second hinge assembly 300b, and the fourth sub-portion 3128 is connected to the second hinge assembly 300b.

In some embodiments, at least one of the first sub-portion 3129, the second sub-portion 3119, the third sub-portion 3118, and the fourth sub-portion 3128 may be connected to the flexible display 30, so that the flexible display 30 may be fastened to the support plate 310.

In some embodiments, none of the first sub-portion 3129, the second sub-portion 3119, the third sub-portion 3118, and the fourth sub-portion 3128 is fastened to the flexible display 30, so that the flexible display 30 may be in a free bending form. Herein, the "free bending form" may be understood as meaning that bending forms of the first sub-portion 3129, the second sub-portion 3119, the third sub-portion 3118, and the fourth sub-portion 3128 are irrelevant to the flexible display.

FIG. 5 is a sectional view of the foldable electronic device 1 in FIG. 2 in an unfolded state along a B-B section line. As shown in FIG. 5, when the two hinge assemblies 300 are in the unfolded state, the second parts 312 and the first parts 311 are arranged in the second direction Y, and the two first parts 311 are located between the two second parts 312. At least parts of the first parts 311 and the second parts 312 jointly form a support plane N, and the support plane N is located on a side that is of the hinge assembly 300 and that is away from the main shaft 100. When the two hinge assemblies 300 are in the unfolded state, for each hinge assembly 300, at least parts of the first part 311 and the second part 312 of the support plate 310 may be flush, so that the at least parts of the first part 311 and the second part 312 jointly form the support plane N.

Herein, "at least a part of the second part 312" may be understood as meaning that the entire second part 312 may be flush with the first part 311, or a part of the second part 312 may be flush with the first part 311. As shown in FIG. 5, the second part 312 may include a flat plate segment 312c and an arc-shaped segment 312d. The flat plate segment 312c may be located between the arc-shaped segment 312d and the first part 311, and the arc-shaped segment 312d may be bent in a direction away from the flexible display 30. In this case, that a part of the second part 312 is flush with the first part 311 may be understood as meaning that the flat plate segment 312c of the second part 312 is flush with the first part 311.

For example, when the two hinge assemblies 300 are in the unfolded state, the first sub-portion 3129, the second sub-portion 3119, the third sub-portion 3118, and the fourth sub-portion 3128 are sequentially arranged in the second direction Y. The first sub-portion 3129, the second sub-portion 3119, the third sub-portion 3118, and the fourth sub-portion 3128 jointly form the support plane. The support plane N may be configured to support the flexible display 30, to improve flatness of the flexible display 30 in the unfolded state. Herein, the "support plane N" may be understood as a plane or an approximate plane. The plane may be a surface parallel to the first direction X and the second direction Y, the approximate plane may be a surface with a slight fluctuation, and an acceptable deviation range of the approximate plane may be, for example, a deviation within 5%.

In some embodiments, the flexible display 30 may be fastened to the support plate 310 by using the adhesive layer 40. A thickness of the adhesive layer 40 between the flexible display 30 and the support plate 310 may be adjusted, to adjust an effect of supporting the flexible display 30 by the support plate 310, so as to ensure that the flexible display 30 is in the unfolded state. In this case, "jointly forming the support plane N" may also be understood as meaning that the first sub-portion 3129, the second sub-portion 3119, the third sub-portion 3118, and the fourth sub-portion 3128 jointly form the support plane N by adjusting the thickness of the adhesive layer 40 between the flexible display 30 and the support plate 310, to ensure the unfolded state when the flexible display 30 is flattened.

For example, when the two hinge assemblies 300 are in the unfolded state, in the second direction Y, a second end 3129b of the first sub-portion, a first end 3129a of the first sub-portion, a second end 3119b of the second sub-portion, a first end 3119a of the second sub-portion, a first end 3118a of the third sub-portion, a second end 3118b of the third sub-portion, a first end 3128a of the fourth sub-portion, and a second end 3128b of the fourth sub-portion are sequentially arranged. A distance between the first end 3119a of the second sub-portion and the first end 3118a of the third sub-portion in the second direction is a first distance D1. In some embodiments, the first end 3119a of the second sub-portion and the first end 3118a of the third sub-portion may be in contact with each other, that is, the first distance D1 is zero. In some other embodiments, the first end 3119a of the second sub-portion and the first end 3118a of the third sub-portion may be close to each other, and there is a small gap between the two ends. A width of the gap in the second direction Y is the first distance D1.

In some examples, in a direction perpendicular to the support plane N (that is, in the third direction Z), the first sub-portion 3129 and the main shaft 100 at least partially overlap, and the second sub-portion 3119 and the main shaft 100 at least partially overlap. For example, in the direction perpendicular to the support plane N, an orthographic projection of the first sub-portion 3129 on the support plane N and an orthographic projection of the main shaft 100 on the support plane N at least partially overlap, and an orthographic projection of the second sub-portion 3119 on the support plane N and an orthographic projection of the main shaft 100 on the support plane N at least partially overlap. The foregoing arrangement helps reduce a dimension of the rotating mechanism 10 in the second direction Y, thereby facilitating a thinner and lighter foldable electronic device 1.

In a process in which the rotating mechanism 10 switches from the unfolded state to a folded state, the first sub-portion 3129, the second sub-portion 3119, the third sub-portion 3118, and the fourth sub-portion 3128 rotate relative to the main shaft, and none of the four sub-portions of the support plate 310 is bent. The first sub-portion 3129 is connected to the first hinge assembly 300a, the second sub-portion 3119 is connected to the first hinge assembly 300a, the third sub-portion 3118 is connected to the second hinge assembly 300b, and the fourth sub-portion 3128 is connected to the second hinge assembly 300b. Because the first hinge assembly 300a is rotatably connected to the main shaft 100, when the first hinge assembly 300a rotates relative to the main shaft 100, the first sub-portion 3129 and the second sub-portion 3119 also rotate relative to the main shaft 100. Because the second hinge assembly 300b is rotatably connected to the main shaft 100, when the second hinge assembly 300b rotates relative to the main shaft 100, the first sub-portion 3129 and the second sub-portion 3119 also rotate relative to the main shaft 100. Herein, "none undergoes bending" may be understood as meaning that none of the four sub-portions of the support plate 310 is elastically deformed from a macro perspective. For example, the first sub-portion 3129, the second sub-portion 3119, the third sub-portion 3118, and the fourth sub-portion 3128 may all be made of rigid materials, and in the process in which the rotating mechanism 10 switches from the unfolded state to the folded state, none of structural shapes of the four sub-portions of the support plate 310 from a macro perspective changes.

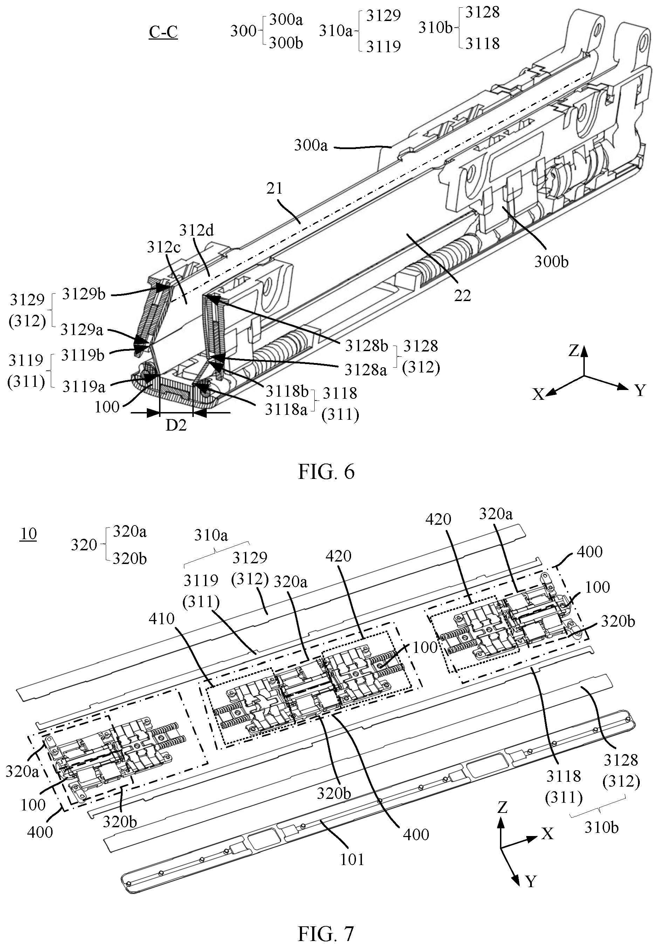

FIG. 6 is a sectional view of the foldable electronic device 1 in FIG. 2 in a folded state along a C-C section line. As shown in FIG. 6, when the two hinge assemblies 300 are in the folded state, a distance between the first end 3129a of the first sub-portion and the first end 3128a of the fourth sub-portion is greater than a distance between the second end 3129b of the first sub-portion and the second end 3128b of the fourth sub-portion in the second direction Y, a distance between the first end 3119a of the second sub-portion and the first end 3118a of the third sub-portion is less than a distance between the second end 3119b of the second sub-portion and the second end 3118b of the third sub-portion in the second direction Y, the distance between the first end 3119a of the second sub-portion and the first end 3118a of the third sub-portion in the second direction Y is a second distance D2, and the second distance D2 is greater than the first distance D1.

When the two hinge assemblies 300 are in the folded state, the first sub-portion 3129, the second sub-portion 3119, the third sub-portion 3118, the fourth sub-portion 3128, and the main shaft 100 jointly form screen accommodating space M. In the same support plate 310, there may be a bending angle between the first part 311 and the second part 312. For example, an included angle between the first sub-portion 3129 and the second sub-portion 3119 may be an obtuse angle, and an included angle between the third sub-portion 3118 and the fourth sub-portion 3128 may be an obtuse angle. There may also be a bending angle between the first part 311 and the main shaft 100. For example, an included angle between the second sub-portion 3119 and the main shaft 100 may be an obtuse angle, and an included angle between the third sub-portion 3118 and the main shaft 100 may be an obtuse angle. Through the foregoing arrangement, as shown in FIG. 4, the flexible display 30 may be bent into a teardrop shape or an approximate teardrop shape in the screen accommodating space M enclosed by the first sub-portion 3129, the second sub-portion 3119, the third sub-portion 3118, the fourth sub-portion 3128, and the main shaft 100, to avoid excessive extrusion on the flexible display 30, thereby reducing stress of the flexible display 30 and improving reliability of the flexible display 30.

In addition, the second distance D2 is greater than the first distance D1. When the two hinge assemblies 300 are in the unfolded state, the distance between the first end 3119a of the second sub-portion and the first end 3118a of the third sub-portion decreases. This helps improve a support effect of the flexible display 30. When the two hinge assemblies 300 are in the folded state, the distance between the first end 3119a of the second sub-portion and the first end 3118a of the third sub-portion increases. This helps further enlarge the screen accommodating space M enclosed by the first sub-portion 3129, the second sub-portion 3119, the third sub-portion 3118, the fourth sub-portion 3128, and the main shaft 100, thereby further improving reliability of the flexible display 30.

When the two hinge assemblies 300 are in the folded state, that the distance between the first end 3129a of the first sub-portion and the first end 3128a of the fourth sub-portion is greater than the distance between the second end 3129b of the first sub-portion and the second end 3128b of the fourth sub-portion in the second direction Y may include the following several implementations: In some embodiments, in a direction close to the main shaft 100, a distance between the first sub-portion 3129 and the fourth sub-portion 3128 in the second direction Y gradually increases. For example, the first sub-portion 3129 may include only a flat plate segment 312c, and the fourth sub-portion 3128 may also include only a flat plate segment 312c. In the direction close to the main shaft 100, a spacing between the flat plate segment 312c of the first sub-portion 3129 and the flat plate segment 312c of the fourth sub-portion 3128 in the second direction Y gradually increases. Herein, the "direction close to the main shaft 100" may be a direction parallel to the third direction Z and pointing to the main shaft 100. Through the foregoing arrangement, flatness of the support plane N including the first sub-portion 3129 and the fourth sub-portion 3128 is ensured, thereby ensuring a support effect of the first sub-portion 3129 and the fourth sub-portion 3128. In addition, this helps improve regularity of the first sub-portion 3129 and the fourth sub-portion 3128, and improve preparation efficiency of the first sub-portion 3129 and the fourth sub-portion 3128.

In some other embodiments, when the two hinge assemblies 300 are in the folded state, in a direction close to the main shaft 100, a distance between the first sub-portion 3129 and the fourth sub-portion 3128 in the second direction Y first decreases and then increases. For example, as shown in FIG. 6, the first sub-portion 3129 may include a flat plate segment 312c and an arc-shaped segment 312d. The arc-shaped segment 312d is closer to the first end 3129a of the first sub-portion compared with the flat plate segment 312c. Similarly, the fourth sub-portion 3128 may also include a flat plate segment 312c and an arc-shaped segment 312d. The arc-shaped segment 312d is closer to the first end 3128a of the fourth sub-portion compared with the flat plate segment 312c. In the direction close to the main shaft 100, a spacing between the arc-shaped segment 312d of the first sub-portion 3129 and the arc-shaped segment 312d of the fourth sub-portion 3128 in the second direction Y gradually decreases. A spacing between the flat plate segment 312c of the first sub-portion 3129 and the flat plate segment 312c of the fourth sub-portion 3128 in the second direction Y gradually increases. Herein, the "direction close to the main shaft 100" may be a direction parallel to the third direction Z and pointing to the main shaft 100. Through the foregoing arrangement, when the two hinge assemblies 300 are in the folded state, interference between the flexible display 30 and the second end 3129b of the first sub-portion and the second end 3128b of the fourth sub-portion can be avoided, thereby helping improve reliability of the flexible display 30.

Certainly, in some other embodiments, when the two hinge assemblies 300 are in the folded state, in a direction close to the main shaft 100, a distance between the first sub-portion 3129 and the fourth sub-portion 3128 in the second direction Y first increases and then decreases. Herein, the "direction close to the main shaft 100" may be a direction parallel to the third direction Z and pointing to the main shaft 100. Through the foregoing arrangement, the spacing between the first sub-portion 3129 and the fourth sub-portion 3128 in the second direction Y increases. This helps further enlarge the screen accommodating space M enclosed by the first sub-portion 3129, the second sub-portion 3119, the third sub-portion 3118, the fourth sub-portion 3128, and the main shaft 100.

Similarly, when the two hinge assemblies 300 are in the folded state, that the distance between the first end 3119a of the second sub-portion and the first end 3118a of the third sub-portion is less than the distance between the second end 3119b of the second sub-portion and the second end 3118b of the third sub-portion in the second direction Y may also include the following several implementations: In some embodiments, in a direction close to the main shaft 100, a distance between the second sub-portion 3119 and the third sub-portion 3118 in the second direction Y gradually decreases. For example, the second sub-portion 3119 and the third sub-portion 3118 each may be of a flat plate structure. Herein, the "direction close to the main shaft 100" may be a direction parallel to the third direction Z and pointing to the main shaft 100. Through the foregoing arrangement, flatness of the support plane N including the second sub-portion 3119 and the third sub-portion 3118 is ensured, thereby ensuring a support effect of the second sub-portion 3119 and the third sub-portion 3118. In addition, this helps improve regularity of the second sub-portion 3119 and the third sub-portion 3118, and improve preparation efficiency of the second sub-portion 3119 and the third sub-portion 3118.

In some other embodiments, when the two hinge assemblies 300 are in the folded state, in a direction close to the main shaft 100, a distance between the second sub-portion 3119 and the third sub-portion 3118 in the second direction Y first decreases and then increases. Herein, the "direction close to the main shaft 100" may be a direction parallel to the third direction Z and pointing to the main shaft 100. Through the foregoing arrangement, when the two hinge assemblies 300 are in the unfolded state, an effect of improving a crease of the flexible display 30 by the second sub-portion 3119 and the third sub-portion 3118 is further improved. Alternatively, in some other embodiments, when the two hinge assemblies 300 are in the folded state, in a direction close to the main shaft 100, a distance between the second sub-portion 3119 and the third sub-portion 3118 in the second direction Y first increases and then decreases. Herein, the "direction close to the main shaft 100" may be a direction parallel to the third direction Z and pointing to the main shaft 100. The foregoing arrangement helps further enlarge the screen accommodating space M enclosed by the first sub-portion 3129, the second sub-portion 3119, the third sub-portion 3118, the fourth sub-portion 3128, and the main shaft 100.

FIG. 7 is an exploded view of a structure of the rotating mechanism 10 according to an embodiment of this application. As shown in FIG. 7, the hinge assembly 300 further includes a rotating portion 320. The rotating portion 320 may be rotatably connected to the main shaft 100, to drive the two hinge assemblies 300 to fold or unfold. For example, two rotating portions 320 include a first rotating portion 320a and a second rotating portion 320b, the first hinge assembly 300a may include the first rotating portion 320a, the first rotating portion 320a is rotatably connected to the main shaft 100, the second hinge assembly 300b may include the second rotating portion 320b, and the second rotating portion 320b is rotatably connected to the main shaft 100.

The rotating portion 320 may be further connected to the support plate 310, so that the support plate 310 can rotate relative to the main shaft 100. For example, the first rotating portion 320a may be connected to the first support plate 310a, and the second rotating portion 320b may be connected to the second support plate 310b. When the two hinge assemblies 300 are in the unfolded state, the first sub-portion 3129, the second sub-portion 3119, the third sub-portion 3118, and the fourth sub-portion 3128 can rotate to a flush state, so as to form the support plane N that supports the flexible display 30. When the two hinge assemblies 300 are in the folded state, the distance between the first end 3129a of the first sub-portion and the first end 3128a of the fourth sub-portion is greater than the distance between the second end 3129b of the first sub-portion and the second end 3128b of the fourth sub-portion in the second direction Y, the distance between the first end 3119a of the second sub-portion and the first end 3118a of the third sub-portion is less than the distance between the second end 3119b of the second sub-portion and the second end 3118b of the third sub-portion in the second direction Y, and the distance between the first end 3119a of the second sub-portion and the first end 3118a of the third sub-portion in the second direction Y increases, to avoid excessive extrusion of the enclosed screen accommodating space M on the flexible display 30.

Still refer to FIG. 7. The rotating mechanism 10 may include a plurality of rotating modules 400 disposed at an interval in the first direction X. A quantity of rotating modules 400 may be correspondingly set based on a width of the foldable electronic device 1. For example, when the width of the foldable electronic device 1 increases, the quantity of rotating modules 400 may be increased to ensure a rotation effect of the foldable electronic device 1. Each rotating module 400 may include a first rotating portion 320a and a second rotating portion 320b, and a plurality of rotating portions 320 disposed in the first direction X in the plurality of rotating modules 400 may be connected to a same support plate 310.

Correspondingly, there may be a plurality of main shafts 100, the plurality of main shafts 100 are disposed at an interval in the first direction X, and one main shaft 100 is rotatably connected to a first rotating portion 320a and a second rotating portion 320b in one rotating module 400. Further, the rotating mechanism 10 may further include a back cover 101, the back cover 101 and the main shaft 100 are stacked in the third direction Z, an extension direction of the back cover 101 may be parallel to the first direction X, and the plurality of main shafts 100 may be mounted on the back cover 101. Through the foregoing arrangement, the rotating portions 320 in the plurality of rotating modules 400 may rotate relative to the same back cover 101. The back cover 101 may include an outer surface E. The outer surface E may be a surface that is of the back cover 101 and that is away from the main shaft 100. The outer surface E is used to display an appearance.

Alternatively, in some other examples, there may be one main shaft 100, and a plurality of rotating modules 400 may be mounted on the one main shaft 100. This is not specifically limited in embodiments of this application.

In some embodiments, the rotating module 400 may further include a first structural portion 420 and a second structural portion 410. For example, the rotating mechanism 10 shown in FIG. 7 may include three rotating modules 400. A rotating module 400 located in the middle may include a first rotating portion 320a, a second rotating portion 320b, a first structural portion 420, and a second structural portion 410. The first structural portion 420 and the second structural portion 410 are located on two sides of the rotating portion 320 in the first direction X. A rotating module 400 located at the edge may include a first structural portion 420, a first rotating portion 320a, and a second rotating portion 320b. The following describes a structure of the rotating module 400 by using only the rotating module 400 located in the middle in FIG. 7 as an example.

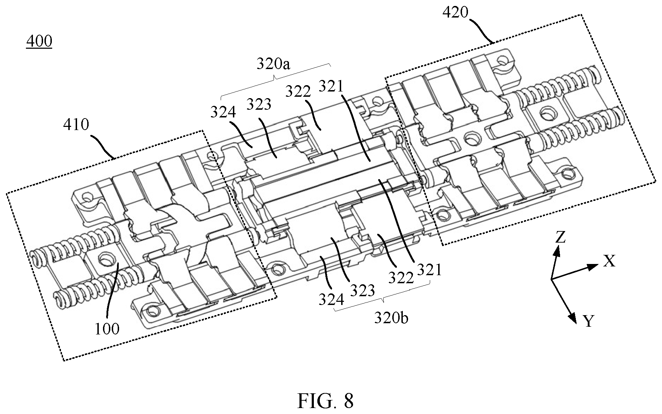

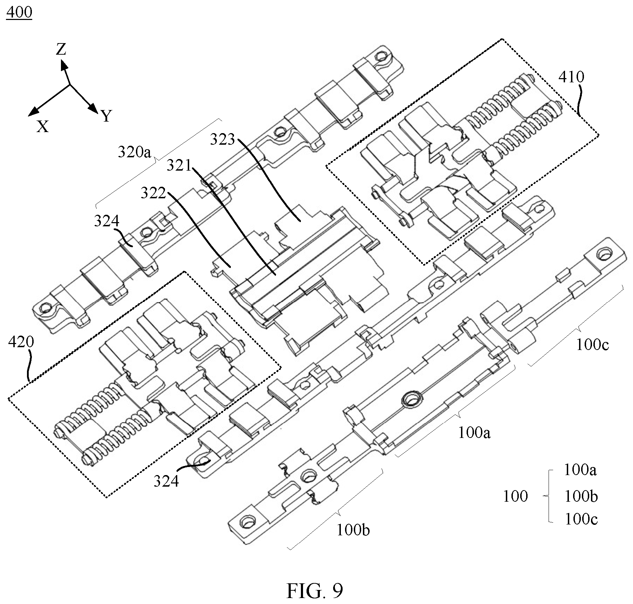

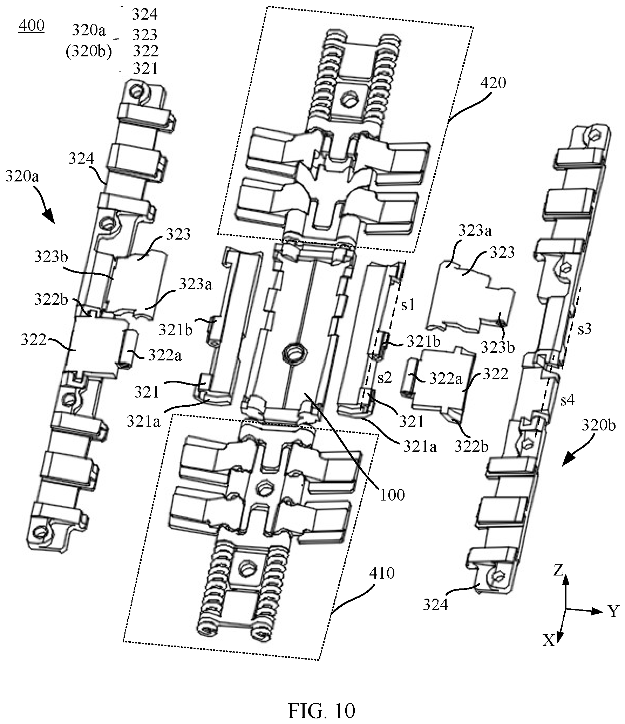

FIG. 8 is a diagram of a structure of a rotating module 400 according to an embodiment of this application. FIG. 9 is an exploded view of a structure of a rotating module 400 according to an embodiment of this application. FIG. 10 is an exploded view of a structure of another rotating module 400 according to an embodiment of this application. As shown in FIG. 8, FIG. 9, and FIG. 10, correspondingly, the main shaft 100 may further include a support fitting portion 100a, and a first fitting portion 100b and a second fitting portion 100c located on two sides of the support fitting portion 100a. The support fitting portion 100a may be in fitting connection to the rotating portion 320, the first fitting portion 100b may be in fitting connection to the first structural portion 420, and the second fitting portion 100c may be in fitting connection to the second structural portion 410.

Still refer to FIG. 8, FIG. 9, and FIG. 10. The first rotating portion 320a may further include a support 324, and the support 324 of the first rotating portion 320a is configured to be fastened to the first mechanical part 21. The support 324 of the first rotating portion 320a may be further connected to the first structural portion 420. Similarly, the second rotating portion 320b may further include a support 324, and the support 324 of the second rotating portion 320b is configured to be fastened to the second mechanical part 22. The support 324 of the second rotating portion 320b may be further connected to the second structural portion 410.

In some embodiments, the first rotating portion 320a may further include a first connecting rod 321 and a second connecting rod 322. In the first rotating portion 320a, a first end 321a of the first connecting rod is rotatably connected to the main shaft 100, a second end 321b of the first connecting rod is rotatably connected to a first end 322a of the second connecting rod, a second end 322b of the second connecting rod is rotatably connected to the support 324 of the first rotating portion 320a, a rotation axis of the second connecting rod 322 relative to the first connecting rod 321 is parallel to the first direction X, a rotation axis of the support 324 of the first rotating portion 320a relative to the second connecting rod 322 is parallel to the first direction X, and a rotation axis of the first connecting rod 321 relative to the main shaft 100 is parallel to the first direction X. Through the foregoing arrangement, in the first rotating portion 320a, the support 324 can rotate relative to the second connecting rod 322 along the rotation axis parallel to the first direction X, the second connecting rod 322 can rotate relative to the first connecting rod 321 along the rotation axis parallel to the first direction X, and the first connecting rod 321 rotates relative to the main shaft 100 along the rotation axis parallel to the first direction X.

Based on the foregoing structure, the first part 311 of the first support plate 310a may be connected to the first connecting rod 321 of the first rotating portion 320a, that is, the second sub-portion 3119 may be connected to the first connecting rod 321 of the first rotating portion 320a; and the second part 312 of the first support plate 310a may be connected to the second connecting rod 322 of the first rotating portion 320a, that is, the first sub-portion 3129 may be connected to the second connecting rod 322 of the first rotating portion 320a. In some embodiments, the second sub-portion 3119 may be fastened to the first connecting rod 321 of the first rotating portion 320a, and the first sub-portion 3129 may be fastened to the second connecting rod 322 of the first rotating portion 320a. For example, the second sub-portion 3119 may be bonded to the first connecting rod 321 of the first rotating portion 320a, or the second sub-portion 3119 may be connected to the first connecting rod 321 of the first rotating portion 320a through a threaded fastener such as a bolt. Similarly, the first sub-portion 3129 may be bonded to the second connecting rod 322 of the first rotating portion 320a, or the first sub-portion 3129 may be connected to the second connecting rod 322 of the first rotating portion 320a through a threaded fastener such as a bolt.

Through the foregoing arrangement, when the first mechanical part 21 drives the support 324 of the first rotating portion 320a to rotate, the support 324 of the first rotating portion 320a can drive the second connecting rod 322 of the first rotating portion 320a to rotate relative to the main shaft 100, so that the first sub-portion 3129 can rotate relative to the main shaft 100; and the second connecting rod 322 of the first rotating portion 320a can drive the first connecting rod 321 of the first rotating portion 320a to rotate relative to the main shaft 100, so that the second sub-portion 3119 can rotate relative to the main shaft 100.

In some other embodiments, the second sub-portion 3119 may be movably connected to the first connecting rod 321 of the first rotating portion 320a, and the first sub-portion 3129 may be movably connected to the second connecting rod 322 of the first rotating portion 320a. For example, the second sub-portion 3119 may be rotatably connected to the first connecting rod 321 of the first rotating portion 320a, so that the second sub-portion 3119 may rotate relative to the first connecting rod 321 of the first rotating portion 320a; and the first sub-portion 3129 may be rotatably connected to the second connecting rod 322 of the first rotating portion 320a, so that the first sub-portion 3129 may rotate relative to the second connecting rod 322 of the first rotating portion 320a. A manner of connecting the second sub-portion 3119 to the first connecting rod 321 of the first rotating portion 320a is not specifically limited in embodiments of this application. A manner of connecting the first sub-portion 3129 to the second connecting rod 322 of the first rotating portion 320a is not specifically limited in embodiments of this application.

A motion principle of a structural component in the second rotating portion 320b may be the same as a motion principle of a structural component in the first rotating portion 320a. In addition, a related structure of the second rotating portion 320b may also be the same as a related structure of the first rotating portion 320a. For example, the second rotating portion 320b may also include a first connecting rod 321 and a second connecting rod 322. In the second rotating portion 320b, a first end 321a of the first connecting rod is rotatably connected to the main shaft 100, a second end 321b of the first connecting rod is rotatably connected to a first end 322a of the second connecting rod, a second end 322b of the second connecting rod is rotatably connected to the support 324 of the second rotating portion 320b, a rotation axis of the second connecting rod 322 relative to the first connecting rod 321 is parallel to the first direction X, a rotation axis of the support 324 of the second rotating portion 320b relative to the second connecting rod 322 is parallel to the first direction X, and a rotation axis of the first connecting rod 321 relative to the main shaft 100 is parallel to the first direction X. Through the foregoing arrangement, in the second rotating portion 320b, the support 324 can rotate relative to the second connecting rod 322 along the rotation axis parallel to the first direction X, the second connecting rod 322 can rotate relative to the first connecting rod 321 along the rotation axis parallel to the first direction X, and the first connecting rod 321 rotates relative to the main shaft 100 along the rotation axis parallel to the first direction X.

Based on the foregoing structure, the first part 311 of the second support plate 310b may be connected to the first connecting rod 321 of the second rotating portion 320b, that is, the third sub-portion 3118 may be connected to the first connecting rod 321 of the second rotating portion 320b; and the second part 312 of the second support plate 310b may be connected to the second connecting rod 322 of the second rotating portion 320b, that is, the fourth sub-portion 3128 may be connected to the second connecting rod 322 of the second rotating portion 320b. In some embodiments, the second sub-portion 3119 may be fastened to the first connecting rod 321 of the second rotating portion 320b, and the first sub-portion 3129 may be fastened to the second connecting rod 322 of the second rotating portion 320b. For example, the third sub-portion 3118 may be bonded to the first connecting rod 321 of the second rotating portion 320b, or the third sub-portion 3118 may be connected to the first connecting rod 321 of the second rotating portion 320b through a threaded fastener such as a bolt. Similarly, the fourth sub-portion 3128 may be bonded to the second connecting rod 322 of the second rotating portion 320b, or the fourth sub-portion 3128 may be connected to the second connecting rod 322 of the second rotating portion 320b through a threaded fastener such as a bolt.

Through the foregoing arrangement, when the second mechanical part 22 drives the support 324 of the second rotating portion 320b to rotate, the support 324 of the second rotating portion 320b can drive the second connecting rod 322 of the second rotating portion 320b to rotate relative to the main shaft 100, so that the fourth sub-portion 3128 can rotate relative to the main shaft 100; and the second connecting rod 322 of the second rotating portion 320b can drive the first connecting rod 321 of the second rotating portion 320b to rotate relative to the main shaft 100, so that the third sub-portion 3118 can rotate relative to the main shaft 100.

When the hinge assembly 300 is in the unfolded state, the first connecting rod 321 of the first rotating portion 320a can rotate to be flush with the second connecting rod 322 of the first rotating portion 320a, so that the first sub-portion 3129 is flush with the second sub-portion 3119; and the first connecting rod 321 of the second rotating portion 320b can rotate to be flush with the second connecting rod 322 of the second rotating portion 320b, so that the third sub-portion 3118 is flush with the fourth sub-portion 3128. Through the foregoing arrangement, the first sub-portion 3129, the second sub-portion 3119, the third sub-portion 3118, and the fourth sub-portion 3128 can form a part of the support plane N.

When the hinge assembly 300 is in the folded state, the first connecting rod 321 of the first rotating portion 320a can rotate to a specific angle relative to the main shaft 100, the second connecting rod 322 of the first rotating portion 320a can rotate to a specific angle relative to the main shaft 100, the first connecting rod 321 of the second rotating portion 320b can rotate to a specific angle relative to the main shaft 100, and the second connecting rod 322 of the second rotating portion 320b can rotate to a specific angle relative to the main shaft 100. A distance between the first end 3129a of the first sub-portion and the first end 3128a of the fourth sub-portion is greater than a distance between the second end 3129b of the first sub-portion and the second end 3128b of the fourth sub-portion in the second direction Y, a distance between the first end 3119a of the second sub-portion and the first end 3118a of the third sub-portion is less than a distance between the second end 3119b of the second sub-portion and the second end 3118b of the third sub-portion in the second direction Y, and the distance between the first end 3119a of the second sub-portion and the first end 3118a of the third sub-portion in the second direction Y increases. Through the foregoing arrangement, the flexible display 30 may be bent into a teardrop shape or an approximate teardrop shape in the screen accommodating space M enclosed by the first sub-portion 3129, the second sub-portion 3119, the third sub-portion 3118, the fourth sub-portion 3128, and the main shaft 100, to avoid excessive extrusion on the flexible display 30, thereby reducing stress of the flexible display 30.

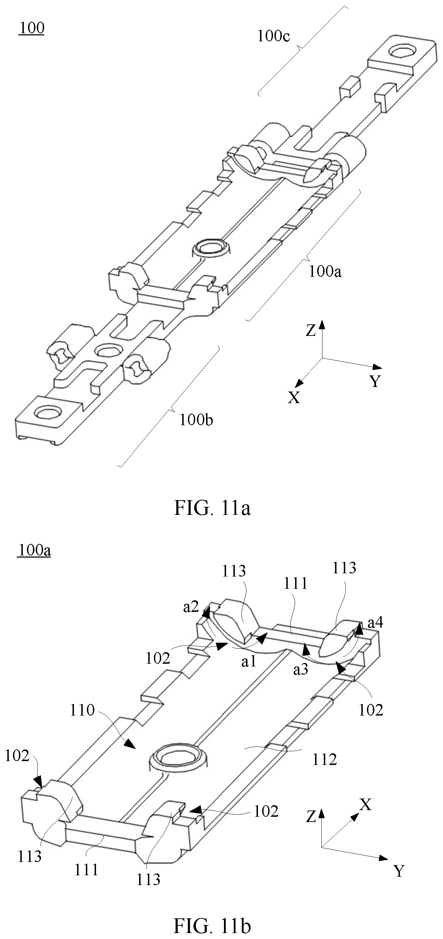

FIG. 11a is a diagram of a structure of a main shaft 100 according to an embodiment of this application. FIG. 11b is a diagram of a structure of a support fitting portion of a main shaft according to an embodiment of this application. Refer to FIG. 11a and FIG. 11b. The main shaft 100 may include a first arc-shaped sliding slot 102. For example, the support fitting portion 100a may include a mounting slot 110, the mounting slot 110 includes two side walls 111 disposed in the first direction X, and a contact block 113 protrudes outward from each side wall 111. A surface that is of the contact block 113 and that faces a slot bottom 112 of the mounting slot is an arc-shaped surface. Correspondingly, the slot bottom 112 of the mounting slot may be an arc-shaped surface that fits with the contact block 113. Through the foregoing arrangement, the slot bottom 112 of the mounting slot and the side walls 111 of the mounting slot jointly enclose two first arc-shaped sliding slots 102 disposed opposite to each other in the first direction X, and the two first arc-shaped sliding slots 102 disposed in the first direction X are configured to be rotatably connected to a same first connecting rod 321. Further, a side wall 111 of each mounting slot has two contact blocks 113 disposed at an interval in the second direction Y. Through the foregoing arrangement, four first arc-shaped sliding slots 102 are jointly enclosed by the slot bottom 112 and the contact blocks 113 of the mounting slot, two first arc-shaped sliding slots 102 arranged in the first direction X form a first sliding slot pair, and two first sliding slot pairs arranged in the second direction Y are disposed at an interval.

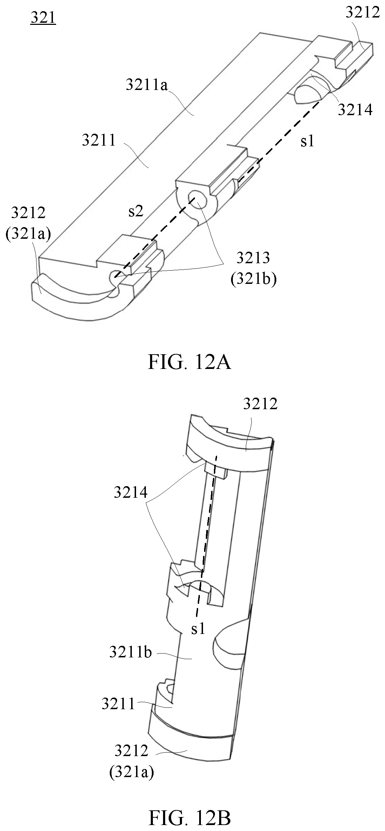

FIG. 12A and FIG. 12B are diagrams of a structure of a first connecting rod 321 according to an embodiment of this application. In some embodiments, the first connecting rod 321 of the second rotating portion 320b may have a same shape as the first connecting rod 321 of the first rotating portion 320a. Alternatively, in some embodiments, the first connecting rod 321 of the second rotating portion 320b may be different from the first connecting rod 321 of the first rotating portion 320a in terms of a shape and a structure, provided that the first connecting rod 321 of the second rotating portion 320b can be rotatably connected to the main shaft 100 of the second rotating portion 320b and the second connecting rod 322 of the second rotating portion 320b, and the first connecting rod 321 of the first rotating portion 320a can be rotatably connected to the main shaft 100 of the first rotating portion 320a and the second connecting rod 322 of the first rotating portion 320a.

The following uses only the first rotating portion 320a as an example to describe a structure of the first connecting rod 321 of the first rotating portion 320a.

FIG. 12A is a diagram of a structure of the first connecting rod 321 from a perspective, and FIG. 12B is a diagram of a structure of the first connecting rod 321 from another perspective. Refer to FIG. 12A and FIG. 12B. The first end 321a of the first connecting rod may include a first arc-shaped sliding block 3212, and the first connecting rod 321 may further include a first body 3211. The first arc-shaped sliding block 3212 is connected to the first body 3211, and the first arc-shaped sliding block 3212 is slidably connected to the first arc-shaped sliding slot 102. For example, the first body 3211 is approximately of a columnar structure, a surface that is of the first body 3211 and that is close to the main shaft 100 may include a first fitting surface 3211b, and the first fitting surface 3211b is an arc-shaped surface and fits with the slot bottom 112 of the mounting slot. A surface that is of the first connecting rod 321 and that is away from the main shaft 100 in the third direction Z may include a first mounting surface 3211a, and the first mounting surface 3211a is configured to connect to the first part 311. For example, the first mounting surface 3211a may be a plane, so that the plane is connected to the first part 311.

Further, there may be two first arc-shaped sliding blocks 3212, and the two first arc-shaped sliding blocks 3212 are respectively connected to two surfaces of the first body 3211 disposed in the first direction X. Through the foregoing arrangement, the first connecting rod 321 can be mounted inside the mounting slot 110 of the main shaft 100, and the first connecting rod 321 can be rotatably connected to the main shaft 100 in a connection manner with a virtual shaft. In addition, the two first arc-shaped sliding blocks 3212 are located on two sides of the first body 3211 in the first direction X. This helps improve assembly compactness of the first connecting rod 321 and the main shaft 100, and then helps reduce a size of the rotating mechanism.

In conclusion, as shown in FIG. 10, FIG. 11a, FIG. 11b, and FIG. 12A and FIG. 12B, the first connecting rod 321 is rotatably connected to the main shaft 100 through the first arc-shaped sliding block 3212 and the first arc-shaped sliding slot 102, the first connecting rod 321 is rotatably connected to the main shaft 100 in a connection manner with a virtual shaft, and the first connecting rod 321 can rotate relative to the main shaft 100 when the first arc-shaped sliding block 3212 slides along the first arc-shaped sliding slot 102.

In a process in which the two hinge assemblies 300 switch from the folded state to the unfolded state, the first arc-shaped sliding block 3212 slides in the first arc-shaped sliding slot 102 in a direction close to the inside of the mounting slot 110 (for example, the first arc-shaped sliding block 3212 of the first connecting rod 321 of the first rotating portion 320a slides in a direction a1 in FIG. 11b, and the first arc-shaped sliding block 3212 of the first connecting rod 321 of the second rotating portion 320b slides in a direction a3 in FIG. 11b), the first arc-shaped sliding block 3212 slides into the first arc-shaped sliding slot 102, and a part of the first arc-shaped sliding block 3212 located in the first arc-shaped sliding slot 102 gradually increases, so that the first ends 321a of the two first connecting rods 321 approach each other, and then the first end 3119a of the second sub-portion and the first end 3118a of the third sub-portion approach each other. This helps improve a support effect for the flexible display 30.

In a process in which the two hinge assemblies 300 switch from the unfolded state to the folded state, the first arc-shaped sliding block 3212 slides in the first arc-shaped sliding slot 102 in a direction close to the edge of the mounting slot 110 (for example, the first arc-shaped sliding block 3212 of the first connecting rod 321 of the first rotating portion 320a slides in a direction a2 in FIG. 11b, and the first arc-shaped sliding block 3212 of the first connecting rod 321 of the second rotating portion 320b slides in a direction a4 in FIG. 11b), the first arc-shaped sliding block 3212 slides out of the first arc-shaped sliding slot 102, and a part of the first arc-shaped sliding block 3212 located in the first arc-shaped sliding slot 102 gradually decreases, so that the first ends 321a of the two first connecting rods 321 move away from each other, and then the first end 3119a of the second sub-portion and the first end 3118a of the third sub-portion move away from each other. This helps further enlarge the screen accommodating space M enclosed by the first sub-portion 3129, the second sub-portion 3119, the third sub-portion 3118, the fourth sub-portion 3128, and the main shaft 100, thereby further improving reliability of the flexible display 30.

In addition, in some other embodiments, the main shaft 100 may include the first arc-shaped sliding block 3212, and the first end 321a of the first connecting rod may include the first arc-shaped sliding slot 102, so that the first connecting rod 321 and the main shaft 100 are rotatably connected through the first arc-shaped sliding block 3212 and the first arc-shaped sliding slot 102.

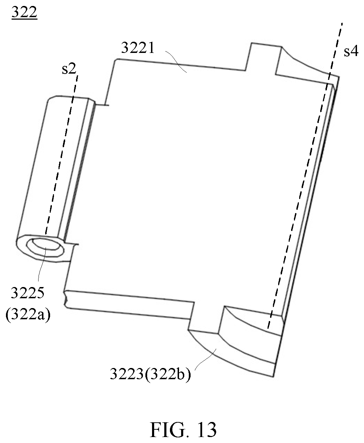

FIG. 13 is a diagram of a structure of a second connecting rod 322 according to an embodiment of this application. In some embodiments, the second connecting rod 322 of the second rotating portion 320b may have a same shape as the second connecting rod 322 of the first rotating portion 320a. Alternatively, in some embodiments, the second connecting rod 322 of the second rotating portion 320b may be different from the second connecting rod 322 of the first rotating portion 320a in terms of a shape and a structure, provided that the second connecting rod 322 of the second rotating portion 320b can be rotatably connected to the first connecting rod 321 of the second rotating portion 320b and the support 324 of the second rotating portion 320b, and the second connecting rod 322 of the first rotating portion 320a can be rotatably connected to the first connecting rod 321 of the first rotating portion 320a and the support 324 of the first rotating portion 320a.

The following uses only the first rotating portion 320a as an example to describe a structure of the second connecting rod 322 of the first rotating portion 320a.

Refer to FIG. 13. The first end 322a of the second connecting rod may include a second connection hole 3225. For example, the second connecting rod 322 may include a second body 3221, and the second body 3221 may be approximately of a flat plate structure, so that the second part 312 is connected to the second body 3221. The second connection hole 3225 runs through the second body 3221, and a central axis of the second connection hole 3225 is parallel to the first direction X.

Correspondingly, with reference to FIG. 12A and FIG. 12B and FIG. 10, the second end 321b of the first connecting rod may include a first connection hole 3213, and a central axis of the first connection hole 3213 is parallel to the first direction X. The second end 321b of the first connecting rod may be located on a side that is of the first body 3211 and that is close to the second connecting rod 322, so that the second end 321b of the first connecting rod is rotatably connected to the second connecting rod 322. For example, the first connection hole 3213 may run through the first body 3211. A pin shaft may penetrate the first connection hole 3213 and the second connection hole 3225, so that the first end 322a of the second connecting rod is rotatably connected to the second end 321b of the first connecting rod. The first body 3211 is rotatably connected to the second body 3221 in a rotation manner with a physical shaft. This helps improve rotation precision and connection reliability between the first body 3211 and the second body 3221.

Refer to FIG. 13. The second end 322b of the second connecting rod may further include a second arc-shaped sliding block 3223, and the second body 3221 is connected to the second arc-shaped sliding block 3223. For example, the second connecting rod 322 may include two second arc-shaped sliding blocks 3223 disposed in the first direction X, and the two second arc-shaped sliding blocks 3223 are respectively connected to two sides of the second body 3221.

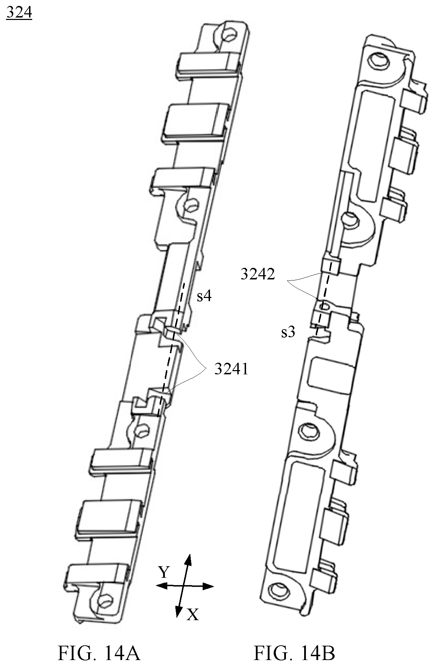

FIG. 14A and FIG. 14B are diagrams of a structure of a support 324 according to an embodiment of this application. FIG. 14A is a diagram of a structure of the support 324 from a perspective, and FIG. 14B is a diagram of a structure of the support 324 from another perspective. Refer to FIG. 14A and FIG. 14B. The support 324 may include a second arc-shaped sliding slot 3241, and the second arc-shaped sliding block 3223 is slidably connected to the second arc-shaped sliding slot 3241. For example, the support 324 may include two second arc-shaped sliding slots 3241, and one second arc-shaped sliding block 3223 of the second connecting rod 322 may be slidably connected to one second arc-shaped sliding slot 3241 of the support 324. Through the foregoing arrangement, the second connecting rod 322 and the support 324 are connected through the second arc-shaped sliding block 3223 and the second arc-shaped sliding slot 3241, so that the second connecting rod 322 is rotatably connected to the support 324 in a connection manner with a virtual shaft.

Further, the second connecting rod 322 is connected to the support 324 by using the virtual shaft, so that a rotation axis of the second connecting rod 322 relative to the support 324 may be closer to the flexible display 30, thereby avoiding pulling the flexible display 30 in a rotation process of the hinge assembly 300. This helps improve reliability of the flexible display 30.

In addition, in some other embodiments, the second end 322b of the second connecting rod may include the second arc-shaped sliding slot 3241, and the support 324 may include the second arc-shaped sliding block 3223, so that the second connecting rod 322 and the support 324 are connected through the second arc-shaped sliding block 3223 and the second arc-shaped sliding slot 3241.

In some implementations, the first connecting rod 321 and the second connecting rod 322 may participate in main motion of the hinge assembly 300, and drive the hinge assembly 300 to rotate relative to the main shaft 100.

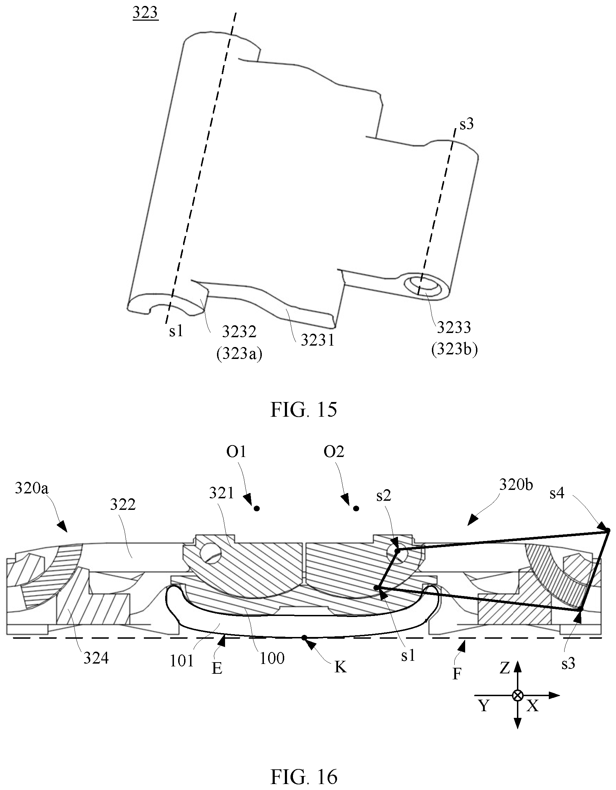

FIG. 15 is a diagram of a structure of a third connecting rod 323 according to an embodiment of this application. With reference to FIG. 10 and FIG. 15, in some implementations, the first rotating portion 320a may further include the third connecting rod 323. The third connecting rod 323 and the second connecting rod 322 may be sequentially arranged in the first direction X. This helps reduce a thickness of the first rotating portion 320a, thereby facilitating a thinner and lighter foldable electronic device. In the first rotating portion 320a, a first end 323a of the third connecting rod is rotatably connected to the first connecting rod 321, and a second end 323b of the third connecting rod is rotatably connected to the support 324 of the first rotating portion 320a.

A motion principle of a structural component in the second rotating portion 320b may be the same as a motion principle of a structural component in the first rotating portion 320a. In addition, a related structure of the second rotating portion 320b may also be the same as a related structure of the first rotating portion 320a. For example, the second rotating portion 320b may further include a third connecting rod 323. In the second rotating portion 320b, a first end 323a of the third connecting rod is rotatably connected to the first connecting rod 321, and a second end 323b of the third connecting rod is rotatably connected to the support 324 of the second rotating portion 320b.

In some embodiments, the third connecting rod 323 of the second rotating portion 320b may have a same shape as the third connecting rod 323 of the first rotating portion 320a. Alternatively, in some embodiments, the third connecting rod 323 of the second rotating portion 320b may be different from the third connecting rod 323 of the first rotating portion 320a in terms of a shape and a structure, provided that the third connecting rod 323 of the second rotating portion 320b can be rotatably connected to the first connecting rod 321 of the second rotating portion 320b and the support 324 of the second rotating portion 320b, and the third connecting rod 323 of the first rotating portion 320a can be rotatably connected to the first connecting rod 321 of the first rotating portion 320a and the support 324 of the first rotating portion 320a.

The following uses only the first rotating portion 320a as an example to describe a structure of the third connecting rod 323 of the first rotating portion 320a.

As shown in FIG. 12A and FIG. 12B to FIG. 15, a rotation axis of the third connecting rod 323 relative to the first connecting rod 321 is a first axis s1. With reference to FIG. 10, the first axis s1 is parallel to the first direction X. A rotation axis of the third connecting rod 323 relative to the support 324 is a third axis s3, and the third axis s3 is parallel to the first direction X. A rotation axis of the second connecting rod 322 relative to the support 324 is a fourth axis s4, and a rotation axis of the second connecting rod 322 relative to the first connecting rod 321 is a second axis s2. As described in the foregoing embodiment, both the second axis s2 and the fourth axis s4 are parallel to the first direction X.

The second end 323b of the third connecting rod may include a third connection hole 3233. For example, the third connecting rod 323 may include a third body 3231, and the third body 3231 may be approximately of a plate structure. The third connection hole 3233 runs through the third body 3231, and an axis of the third connection hole 3233 is parallel to the first direction X. Correspondingly, with reference to FIG. 14A and FIG. 14B, the support 324 may include a support connection hole 3242, and a central axis of the support connection hole 3242 is parallel to the first direction X. A pin shaft may penetrate the third connection hole 3233 and the support connection hole 3242, so that the third body 3231 is rotatably connected to the support 324 in a rotation manner with a physical shaft.

It may be understood that, because the rotation manner with the virtual shaft needs to be provided with an arc-shaped sliding slot and an arc-shaped sliding block that fit with each other, large space needs to be occupied. The third connecting rod 323 is rotatably connected to the support 324 in a connection manner with a physical shaft. This helps reduce a size of the support 324 and improve reliability of connection between the third connecting rod 323 and the support 324.

The first end 323a of the third connecting rod may include a third arc-shaped sliding block 3232, and the third arc-shaped sliding block 3232 is connected to the third body 3231. For example, the third connecting rod 323 may include two third arc-shaped sliding blocks 3232 disposed in the first direction X, and the two third arc-shaped sliding blocks 3232 are respectively connected to two sides of the third body 3231. With reference to FIG. 12A and FIG. 12B, the first connecting rod 321 may include a third arc-shaped sliding slot 3214, and the third arc-shaped sliding block 3232 is slidably connected to the third arc-shaped sliding slot 3214. For example, the first connecting rod 321 may include two third arc-shaped sliding slots 3214, and one third arc-shaped sliding block 3232 of the third connecting rod 323 may be slidably connected to one third arc-shaped sliding slot 3214 of the first connecting rod 321. Through the foregoing arrangement, the third connecting rod 323 is rotatably connected to the first connecting rod 321 through the third arc-shaped sliding block 3232 and the third arc-shaped sliding slot 3214, so that the third connecting rod 323 is rotatably connected to the first connecting rod 321 in a connection manner with a virtual shaft.

Alternatively, in some other embodiments, the first end 323a of the third connecting rod may include the third arc-shaped sliding slot 3214, and the first connecting rod 321 may include the third arc-shaped sliding block 3232, so that the third connecting rod 323 is rotatably connected to the first connecting rod 321 through the third arc-shaped sliding block 3232 and the third arc-shaped sliding slot 3214.

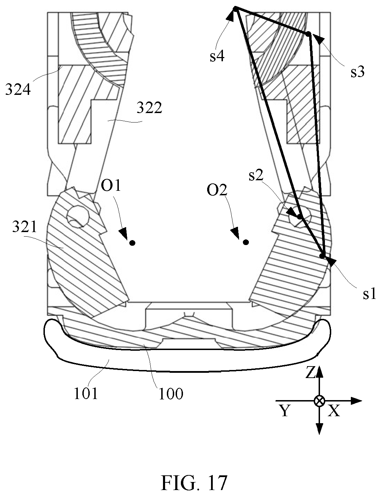

Further, the third connecting rod 323 is connected to the first connecting rod 321 through the virtual shaft, so that a rotation axis of the third connecting rod 323 relative to the first connecting rod 321 may be farther away from the flexible display 30. FIG. 16 is a local sectional view of a rotating mechanism 10 in an unfolded state according to an embodiment of this application. FIG. 17 is a local sectional view of a rotating mechanism 10 in a folded state according to an embodiment of this application.

Refer to FIG. 16. When the two hinge assemblies 300 are in the unfolded state, a distance between the second axis s2 and a reference surface F in the third direction Z is greater than a distance between the first axis s1 and the reference surface F in the third direction Z, the reference surface F is parallel to the first direction X and the second direction Y, and a farthest point (for example, a point K in FIG. 16) on the outer surface E from the support plane in the third direction Z intersects the reference surface F. Through the foregoing arrangement, when the two hinge assemblies 300 are in the unfolded state, the third connecting rod 323 is prevented from pushing the flexible display 30, thereby improving flatness of the flexible display 30.

Based on the foregoing structure, when the two hinge assemblies 300 are in the unfolded state, a distance between the fourth axis s4 and the reference surface F in the third direction Z is greater than a distance between the third axis s3 and the reference surface F in the third direction Z. Through the foregoing arrangement, in the same rotating portion 320, the first connecting rod 321, the second connecting rod 322, the third connecting rod 323, and the support 324 may jointly form a four-connecting-rod mechanism. The four-connecting-rod mechanism may play a main motion effect, and may drive another mechanism connected between the support 324 and the main shaft 100 to move.

For example, a rotation axis of the first connecting rod 321 relative to the main shaft 100 is an overall rotation axis of the four-connecting-rod mechanism. Rotation axes of the two first connecting rods 321 relative to the main shaft 100 do not coincide. For example, a rotation axis of the first connecting rod 321 of the first rotating portion 320a relative to the main shaft 100 may be a rotation axis O1, and a rotation axis of the first connecting rod 321 of the second rotating portion 320b relative to the main shaft 100 may be a rotation axis O1. Only an example in which the rotation axis of the four-connecting-rod mechanism is a rotation axis O2 (that is, the second rotating portion 320b) is used for description below.

In a process in which the hinge assembly 300 switches from the folded state to the unfolded state, the four-connecting-rod mechanism rotates around the rotation axis O2 as a whole, so that two opposite ends of the two first connecting rods 321 move close to each other. In addition, in a process of overall motion of the four-connecting-rod mechanism, the second connecting rod 322 inside the four-connecting-rod mechanism rotates relative to the first connecting rod 321, and the third connecting rod 323 rotates relative to the first connecting rod 321, so that the first connecting rod 321 is flush with at least a part of the second connecting rod 322.

In a process in which the hinge assembly 300 switches from the unfolded state to the folded state, the four-connecting-rod mechanism rotates around the rotation axis O2 as a whole, so that the two first connecting rods 321 rotate relative to the main shaft. In addition, in a process of overall motion of the four-connecting-rod mechanism, the second connecting rod 322 inside the four-connecting-rod mechanism rotates around the second axis s2 relative to the first connecting rod 321, and the third connecting rod 323 rotates around the first axis s1 relative to the first connecting rod 321, so that there is a bending angle between the first connecting rod 321 and the second connecting rod 322. In the second direction Y, a spacing between the first ends 321a of the two first connecting rods 321 is less than a spacing between the second ends 321b of the two first connecting rods 321, and a spacing between the first ends 322a of the two second connecting rods 322 is greater than a spacing between the second ends 322b of the two second connecting rods 322.

In some other implementations, the first connecting rod 321 and the second connecting rod 322 may alternatively not participate in main motion of the hinge assembly 300, and the hinge assembly 300 may alternatively rotate under driving of another main motion structure. In an actual use process, different main motion structures may be disposed in the rotating mechanism 10 according to different requirements.

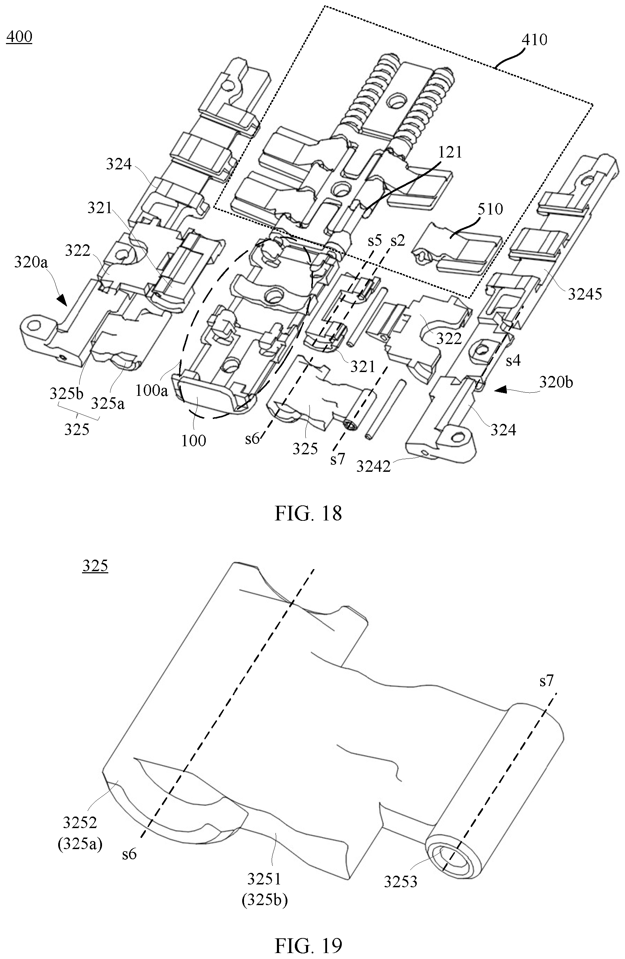

The following describes other main motion structures by using only a rotating module 400 located at an edge position in FIG. 18 as an example. It should be noted that, the main motion structure shown in FIG. 18 may also be applied to a rotating module 400 at another position, for example, may be applied to a rotating module 400 at a middle position and a rotating module 400 at another edge position.

FIG. 18 is an exploded view of a structure of another rotating module 400 according to an embodiment of this application. FIG. 18 provides structures of a first connecting rod 321 and a second connecting rod 322 in another embodiment. For example, the first connecting rod 321 and the second connecting rod 322 in FIG. 18 may not be completely the same as the first connecting rod 321 and the second connecting rod 322 in FIG. 10. For example, a length of the first connecting rod 321 in FIG. 18 in the first direction X is short, and a width of the second connecting rod 322 in FIG. 18 in the second direction Y is increased. Certainly, the first connecting rod 321 and the second connecting rod 322 in embodiments of this application are not limited to the foregoing two structures, provided that the first connecting rod 321 can be rotatably connected to the main shaft 100, the first connecting rod 321 can be rotatably connected to the second connecting rod 322, and the second connecting rod 322 can be rotatably connected to the support 324.

FIG. 19 is a diagram of a structure of a fourth connecting rod 325 according to an embodiment of this application. Refer to FIG. 19. In some implementations, the first rotating portion 320a may further include the fourth connecting rod 325. In the first rotating portion 320a, a first end 325a of the fourth connecting rod may be rotatably connected to the main shaft 100, a second end 325b of the fourth connecting rod is rotatably connected to the support 324 of the first rotating portion 320a, and both a rotation axis of the support 324 of the first rotating portion 320a relative to the fourth connecting rod 325 and a rotation axis of the fourth connecting rod 325 relative to the main shaft 100 are parallel to the first direction X.

A motion principle of a structural component in the second rotating portion 320b may be the same as a motion principle of a structural component in the first rotating portion 320a. In addition, a related structure of the second rotating portion 320b may also be the same as a related structure of the first rotating portion 320a. For example, the second rotating portion 320b may also include a fourth connecting rod 325. In the second rotating portion 320b, a first end 325a of the fourth connecting rod may be rotatably connected to the main shaft 100, a second end 325b of the fourth connecting rod is rotatably connected to the support 324 of the second rotating portion 320b, and both a rotation axis of the support 324 of the second rotating portion 320b relative to the fourth connecting rod 325 and a rotation axis of the fourth connecting rod 325 relative to the main shaft 100 are parallel to the first direction X.

In some embodiments, the fourth connecting rod 325 of the second rotating portion 320b may have a same shape as the fourth connecting rod 325 of the first rotating portion 320a. Alternatively, in some embodiments, the fourth connecting rod 325 of the second rotating portion 320b may be different from the fourth connecting rod 325 of the first rotating portion 320a in terms of a shape and a structure, provided that the fourth connecting rod 325 of the second rotating portion 320b can be rotatably connected to the main shaft 100 and the support 324 of the second rotating portion 320b, and the fourth connecting rod 325 of the first rotating portion 320a can be rotatably connected to the main shaft 100 and the support 324 of the first rotating portion 320a.

The following uses only the first rotating portion 320a as an example to describe a structure of the fourth connecting rod 325 of the first rotating portion 320a.

With reference to FIG. 18, a rotation axis of the first connecting rod 321 relative to the main shaft 100 may be a fifth axis s5, and a rotation axis of the fourth connecting rod 325 relative to the main shaft 100 may be a sixth axis s6. A relative position relationship between the fifth axis s5 and the sixth axis s6 is not specifically limited in embodiments of this application. For example, the fifth axis s5 may coincide with the sixth axis s6, or the fifth axis s5 may be disposed at an interval from the sixth axis s6.

With reference to FIG. 18, a rotation axis of the support 324 of the first rotating portion 320a relative to the fourth connecting rod 325 may be a seventh axis s7. Similarly, a relative position relationship between the seventh axis s7 and the fourth axis s4 is not specifically limited in embodiments of this application. For example, the seventh axis s7 may coincide with the fourth axis s4, or the seventh axis s7 may be disposed at an interval from the fourth axis s4. Disposing the fourth connecting rod 325 helps further improve reliability of connection between the support 324 and the main shaft 100.

The second end 325b of the fourth connecting rod may include a fourth connection hole 3253. For example, the fourth connecting rod 325 may include a fourth body 3251, the fourth body 3251 may be approximately of a plate structure, and the fourth connection hole 3253 may run through the fourth body 3251. Correspondingly, with reference to FIG. 18, the support 324 may further include a support connection hole 3242, and a pin shaft may penetrate the fourth connection hole 3253 and the support connection hole 3242. Through the foregoing arrangement, the second end 325b of the fourth connecting rod may be rotatably connected to the support 324, and the fourth body 3251 and the support 324 can be rotatably connected in a connection manner with a physical shaft. As described in the foregoing embodiment, the fourth connecting rod 325 is rotatably connected to the support 324 in a connection manner with a physical shaft. This helps reduce a size of the support 324 and improve reliability of connection between the fourth connecting rod 325 and the support 324.

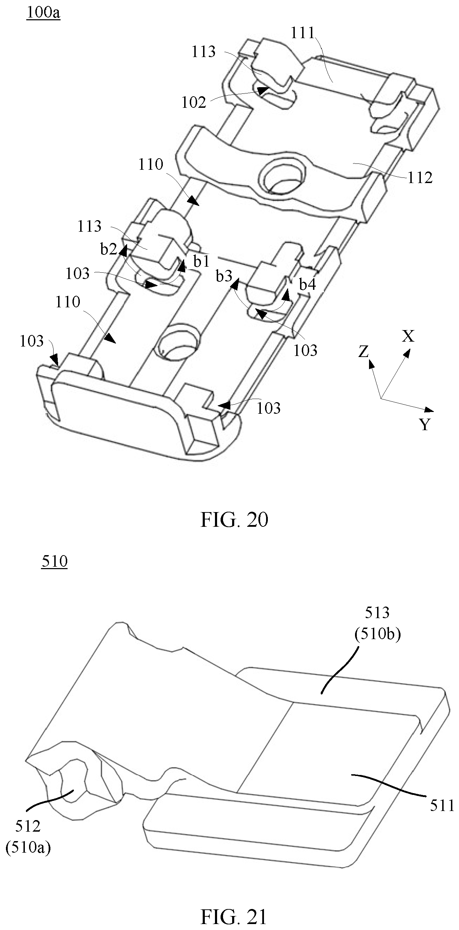

The first end 325a of the fourth connecting rod may include a fourth arc-shaped sliding block 3252, and the fourth arc-shaped sliding block 3252 may be connected to the fourth body 3251. FIG. 20 is a diagram of a structure of a support fitting portion 100a in another main shaft 100 according to an embodiment of this application. The main shaft 100 further includes a fourth arc-shaped sliding slot 103, and the fourth arc-shaped sliding block 3252 is slidably connected to the fourth arc-shaped sliding slot 103. For example, the support fitting portion 100a may include at least two mounting slots 110, at least one mounting slot 110 is configured to be rotatably connected to the first connecting rod 321, and at least one mounting slot 110 is configured to be rotatably connected to the fourth connecting rod 325. As described in the foregoing embodiment, the slot bottom 112 of the mounting slot and the contact blocks 113 jointly enclose two fourth arc-shaped sliding slots 103 disposed opposite to each other in the first direction X, and the two fourth arc-shaped sliding slots 103 disposed opposite to each other in the first direction X are configured to be rotatably connected to a same fourth connecting rod 325. Further, a side wall 111 of each mounting slot has two contact blocks 113 disposed at an interval in the second direction Y. Through the foregoing arrangement, four fourth arc-shaped sliding slots 103 are jointly enclosed by the slot bottom 112 of the mounting slot and the side walls 111 of the mounting slot, two fourth arc-shaped sliding slots 103 disposed opposite to each other in the first direction X form a fourth sliding slot pair, and two fourth sliding slot pairs disposed in the second direction Y are disposed at an interval.

Through the foregoing arrangement, when the first end 325a of the fourth connecting rod is rotatably connected to the main shaft 100 through the fourth arc-shaped sliding block 3252 and the fourth arc-shaped sliding slot 103, and the fourth connecting rod 325 is rotatably connected to the main shaft 100 in a connection manner with a virtual shaft, the fourth connecting rod 325 can rotate relative to the main shaft 100 when the fourth arc-shaped sliding block 3252 slides along the fourth arc-shaped sliding slot 103.

In a process in which the two hinge assemblies 300 switch from the folded state to the unfolded state, the fourth arc-shaped sliding block 3252 slides in the fourth arc-shaped sliding slot 103 in a direction close to the inside of the mounting slot 110 (for example, the fourth arc-shaped sliding block 3252 of the fourth connecting rod 325 of the first rotating portion 320a slides in a direction b1 in FIG. 20, and the fourth arc-shaped sliding block 3252 of the fourth connecting rod 325 of the second rotating portion 320b slides in a direction b3 in FIG. 20), the fourth arc-shaped sliding block 3252 slides into the fourth arc-shaped sliding slot 103, and a part of the fourth arc-shaped sliding block 3252 located in the fourth arc-shaped sliding slot 103 gradually increases, so that the first ends 325a of the two fourth connecting rods approach each other. This helps improve a support effect for the flexible display 30.

When the two hinge assemblies 300 switch from the unfolded state to the folded state, the fourth arc-shaped sliding block 3252 slides in the fourth arc-shaped sliding slot 103 in a direction close to the edge of the mounting slot 110 (for example, the fourth arc-shaped sliding block 3252 of the fourth connecting rod 325 of the first rotating portion 320a slides in a direction b2 in FIG. 20, and the fourth arc-shaped sliding block 3252 of the fourth connecting rod 325 of the second rotating portion 320b slides in a direction b4 in FIG. 20), the fourth arc-shaped sliding block 3252 slides out of the fourth arc-shaped sliding slot 103, and a part of the fourth arc-shaped sliding block 3252 located in the fourth arc-shaped sliding slot 103 gradually decreases, so that the first ends 325a of the two fourth connecting rods move away from each other. This helps further enlarge the screen accommodating space enclosed by the first sub-portion 3129, the second sub-portion 3119, the third sub-portion 3118, the fourth sub-portion 3128, and the main shaft 100, thereby further improving reliability of the flexible display 30.

Alternatively, in some other embodiments, the first end 325a of the fourth connecting rod may include the fourth arc-shaped sliding slot 103, the main shaft 100 may include the fourth arc-shaped sliding block 3252, and the first end 325a of the fourth connecting rod is rotatably connected to the main shaft 100 through the fourth arc-shaped sliding block 3252 and the fourth arc-shaped sliding slot 103.

FIG. 21 is a diagram of a structure of a swing rod 510 according to an embodiment of this application. Based on the foregoing structure, with reference to FIG. 21 and FIG. 18, the first rotating portion 320a may further include the swing rod 510. In the first rotating portion 320a, a first end 510a of the swing rod is rotatably connected to the main shaft 100, a rotation axis of the swing rod 510 relative to the main shaft 100 is parallel to the first direction X, a second end 510b of the swing rod is slidably connected to the support 324, and a sliding direction of the swing rod 510 relative to the support 324 is not parallel to a length extension direction of the support 324.

A motion principle of a structural component in the second rotating portion 320b may be the same as a motion principle of a structural component in the first rotating portion 320a. In addition, a related structure of the second rotating portion 320b may also be the same as a related structure of the first rotating portion 320a. For example, the second rotating portion 320b may also include a swing rod 510. In the second rotating portion 320b, a first end 510a of the swing rod is rotatably connected to the main shaft 100, a rotation axis of the swing rod 510 relative to the main shaft 100 is parallel to the first direction X, a second end 510b of the swing rod is slidably connected to the support 324, and a sliding direction of the swing rod 510 relative to the support 324 is not parallel to a length extension direction of the support 324.

In some embodiments, the swing rod 510 of the second rotating portion 320b may have a same shape as the swing rod 510 of the first rotating portion 320a. Alternatively, in some embodiments, the swing rod 510 of the second rotating portion 320b may be different from the swing rod 510 of the first rotating portion 320a in terms of a shape and a structure, provided that the swing rod 510 of the second rotating portion 320b can be rotatably connected to the main shaft 100, the swing rod 510 of the second rotating portion 320b can be slidably connected to the support 324 of the second rotating portion 320b, the swing rod 510 of the first rotating portion 320a can be rotatably connected to the main shaft 100, and the swing rod 510 of the first rotating portion 320a can be slidably connected to the support 324 of the first rotating portion 320a.

The following uses only the first rotating portion 320a as an example to describe a structure of the fourth connecting rod 325 of the first rotating portion 320a.

In some embodiments, the second end 510b of the swing rod may include a swing rod connection hole 512. For example, with reference to FIG. 18, the swing rod 510 may include a swing rod body 511, and the swing rod connection hole 512 may run through the swing rod body 511. Accordingly, the main shaft 100 may have a main shaft connection hole 121 that runs through the main shaft 100 in the first direction X. A pin shaft may penetrate the main shaft connection hole 121 and the swing rod connection hole 512, so that the swing rod body 511 is rotatably connected to the main shaft 100 through the pin shaft. Through the foregoing arrangement, the swing rod body 511 and the main shaft 100 may be rotatably connected in a connection manner with a physical shaft. This helps improve connection reliability and rotation precision between the swing rod body 511 and the main shaft 100.

Based on the foregoing structure, with reference to FIG. 18 and FIG. 21, the first end 510a of the swing rod may include a swing rod sliding block 513, the swing rod sliding block 513 may be connected to the swing rod body 511, the support 324 may include a support sliding slot 3245, and the swing rod sliding block 513 is slidably connected to the support sliding slot 3245. For example, an extension direction of the support sliding slot 3245 may be perpendicular to an extension direction of the support 324, and the sliding block slides in the support sliding slot 3245, so that the swing rod 510 may be slidably connected to the support 324.

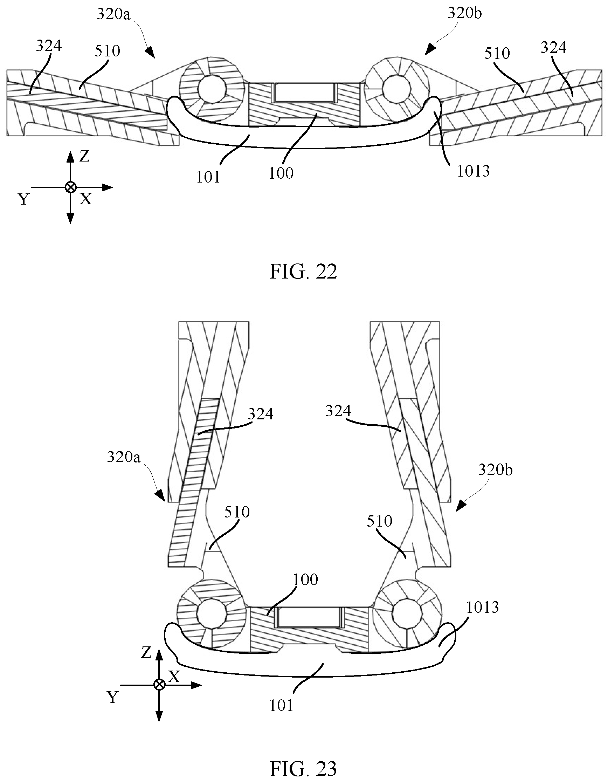

FIG. 22 is a local sectional view of another rotating mechanism 10 in an unfolded state according to an embodiment of this application. FIG. 23 is a local sectional view of another rotating mechanism 10 in a folded state according to an embodiment of this application. Refer to FIG. 22 and FIG. 23. In a process in which the two hinge assemblies 300 switch from the unfolded state to the folded state, the support 324 of the first rotating portion 320a slides relative to the swing rod 510 of the first rotating portion 320a in a direction away from the main shaft 100, and the support 324 of the second rotating portion 320b slides relative to the swing rod 510 of the second rotating portion 320b in a direction away from the main shaft 100. In a process in which the two hinge assemblies 300 switch from the folded state to the unfolded state, the support 324 of the first rotating portion 320a slides relative to the swing rod 510 of the first rotating portion 320a in a direction close to the main shaft 100, and the support 324 of the second rotating portion 320b slides relative to the swing rod 510 of the second rotating portion 320b in a direction close to the main shaft 100. The foregoing arrangement helps adjust a length between two supports 324. In a process of folding or unfolding the two hinge assemblies 300, this helps ensure that a length of the flexible display 30 does not change, and improve a phenomenon of extruding or stretching the flexible display 30 by the rotating mechanism 10.

With reference to FIG. 10, when the two swing rods 510 fit with the first connecting rod 321, the second connecting rod 322, and the third connecting rod 323 in the foregoing embodiment, the swing rods 510 help further restrict a degree of freedom of motion of the foregoing four-connecting-rod mechanism, and helps improve motion precision of the foregoing four-connecting-rod mechanism.

It may be understood that, with reference to FIG. 22 and FIG. 23, in a process in which the two hinge assemblies 300 switch from the unfolded state to the folded state, the support 324 of the first rotating portion 320a may slide relative to the swing rod 510 of the first rotating portion 320a in a direction away from the main shaft 100, and the support 324 of the second rotating portion 320b may slide relative to the swing rod 510 of the second rotating portion 320b in a direction away from the main shaft 100, so that when the two hinge assemblies 300 are in the folded state, there is a specific distance between the flexible display 30 and the main shaft 100. The back cover 101 is located on a side that is of the main shaft 100 and that is away from the flexible display 30, two flanges 1013 are disposed on the back cover 101 in the second direction Y, and the two flanges 1013 are located on two sides of the flexible display 30 in the second direction Y. The flange 1013 of the back cover 101 may shield a part of the flexible display 30 in the second direction Y, to protect the flexible display 30.

In conclusion, when the two hinge assemblies 300 are in the folded state, a distance between the first ends 321a of the two first connecting rods in the second direction Y increases, so that the screen accommodating space M is enlarged. Correspondingly, in a process in which the two hinge assemblies 300 switch from the unfolded state to the folded state, the support 324 of the first rotating portion 320a may slide relative to the swing rod 510 of the first rotating portion 320a by a short distance in a direction away from the main shaft 100, and the support 324 of the second rotating portion 320b may slide relative to the swing rod 510 of the second rotating portion 320b by a short distance in a direction away from the main shaft 100, so that the flexible display 30 may move in a direction close to the main shaft 100. In embodiments of this application, the flange 1013 of the back cover 101 is low. When the two hinge assemblies 300 are in the unfolded state, a thickness of the hinge assembly 300 at a position facing the flange 1013 of the back cover 101 is increased while maintaining a thinner and lighter foldable electronic device 1. This helps improve strength of the hinge assembly 300.

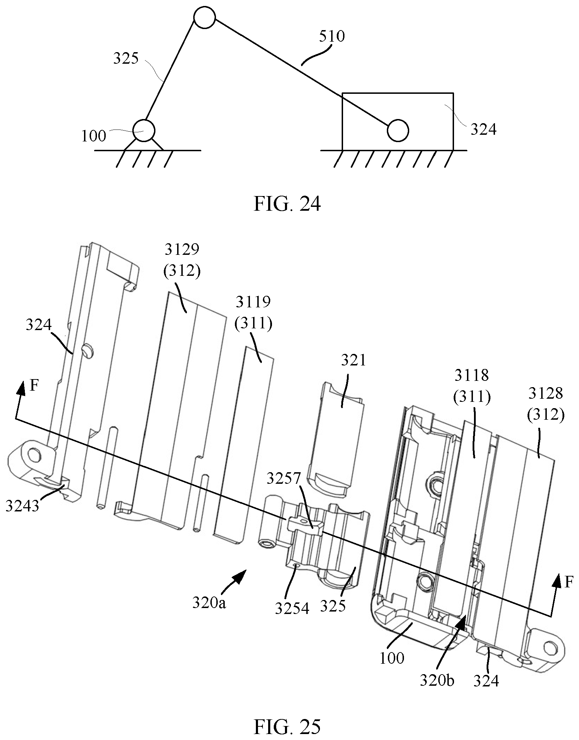

FIG. 24 is a principle diagram of main motion of another rotating mechanism 10 according to an embodiment of this application. With reference to FIG. 18 and FIG. 24, when the two swing rods 510 fit with the first connecting rod 321, the second connecting rod 322, and the fourth connecting rod 325 in the foregoing embodiment, the main shaft 100, the fourth connecting rod 325, the swing rod 510, and the support 324 jointly form a crank sliding block mechanism, and the crank sliding block mechanism can play a main motion effect. While the crank sliding block mechanism plays a role of main motion, the first connecting rod 321 and the second connecting rod 322 play an effect of auxiliary motion.

It may be understood that the crank sliding block mechanism is also referred to as a crank connecting rod mechanism, and is a planar connecting rod mechanism that implements mutual switching between rotation and movement by using a crank and a sliding block. In the crank sliding block mechanism, a member that forms a moving pair with a rack is a sliding block, and a member that connects the crank and the sliding block through a rotating pair is a connecting rod. In embodiments of this application, the swing rod 510 is equivalent to the rack in the crank sliding block mechanism, the support 324 is equivalent to the sliding block in the crank sliding block mechanism, the main shaft 100 is equivalent to the crank in the crank sliding block mechanism, and the fourth connecting rod 325 is equivalent to the connecting rod in the crank sliding block mechanism.

In a process in which the hinge assembly 300 switches from the folded state to the unfolded state, the support 324 of the first rotating portion 320a slides relative to the swing rod 510 of the first rotating portion 320a in a direction close to the main shaft 100, and the support 324 of the second rotating portion 320b slides relative to the swing rod 510 of the second rotating portion 320b in a direction close to the main shaft 100, so that the first ends 321a of the two first connecting rods approach each other. In addition, the second connecting rod 322 rotates relative to the first connecting rod 321, and the third connecting rod 323 rotates relative to the first connecting rod 321, so that the first connecting rod 321 is flush with at least a part of the second connecting rod 322.

When the hinge assemblies 300 switch from the unfolded state to the folded state, the support 324 of the first rotating portion 320a slides relative to the swing rod 510 of the first rotating portion 320a in a direction away from the main shaft 100, and the support 324 of the second rotating portion 320b slides relative to the swing rod 510 of the second rotating portion 320b in a direction away from the main shaft 100, so that the first ends 321a of the two first connecting rods move away from each other. In addition, the second connecting rod 322 rotates relative to the first connecting rod 321, and the third connecting rod 323 rotates relative to the first connecting rod 321, so that there is a bending angle between the first connecting rod 321 and the second connecting rod 322. In the second direction Y, a spacing between the first ends 321a of the two first connecting rods 321 is less than a spacing between the second ends 321b of the two first connecting rods 321, and a spacing between the first ends 322a of the two second connecting rods 322 is greater than a spacing between the second ends 322b of the two second connecting rods 322.

In some other implementations, the first part 311 and the second part 312 may alternatively use other driving manners. FIG. 25 is a local exploded view of another rotating mechanism 10 according to an embodiment of this application. As shown in FIG. 25, the first rotating portion 320a may include the first connecting rod 321 and the fourth connecting rod 325, one end of the fourth connecting rod 325 is rotatably connected to the main shaft 100 in a connection manner with a virtual shaft, the other end of the fourth connecting rod 325 may be rotatably connected to the support 324 of the first rotating portion 320a in a connection manner with a physical shaft, the first connecting rod 321 may be rotatably connected to the main shaft 100 in a connection manner with a virtual shaft, and the first connecting rod 321 may be further connected to the swing rod 510, so that the swing rod 510 can drive the first connecting rod 321 to rotate relative to the main shaft 100. Certainly, in some other examples, the first connecting rod 321 may be alternatively connected to the fourth connecting rod 325, so that the fourth connecting rod 325 can drive the first connecting rod 321 to rotate relative to the main shaft 100.

In an embodiment in which the first rotating portion 320a includes the first connecting rod 321 and the fourth connecting rod 325, the first part 311 of the first support plate 310a may be connected to the first connecting rod 321, that is, the second sub-portion 3119 may be connected to the first connecting rod 321, so that the first connecting rod 321 can drive the second sub-portion 3119 to rotate relative to the main shaft 100. Based on the foregoing structure, one end of the second part 312 of the first support plate 310a may be connected to the fourth connecting rod 325, and the other end of the second part 312 of the first support plate 310a may be rotatably connected to the support 324. For example, one end of the first sub-portion may be connected to the fourth connecting rod 325, and the other end of the first sub-portion may be rotatably connected to the support 324.

As described in the foregoing embodiment, a motion principle of a structural component in the second rotating portion 320b may be the same as a motion principle of a structural component in the first rotating portion 320a. In addition, a related structure of the second rotating portion 320b may also be the same as a related structure of the first rotating portion 320a. For example, the second rotating portion 320b may also include the first connecting rod 321 and the fourth connecting rod 325. Details are not described herein again. In an embodiment in which the second rotating portion 320b includes the first connecting rod 321 and the fourth connecting rod 325, the first part 311 of the second support plate 310b may be connected to the first connecting rod 321, that is, the third sub-portion 3118 may be connected to the first connecting rod 321, so that the first connecting rod 321 can drive the third sub-portion 3118 to rotate relative to the main shaft 100. Based on the foregoing structure, one end of the second part 312 of the second support plate 310b may be connected to the fourth connecting rod 325, and the other end of the second part 312 of the second support plate 310b may be rotatably connected to the support 324 of the second rotating portion 320b. For example, one end of the fourth sub-portion may be connected to the fourth connecting rod 325, and the other end of the fourth sub-portion may be rotatably connected to the support 324.

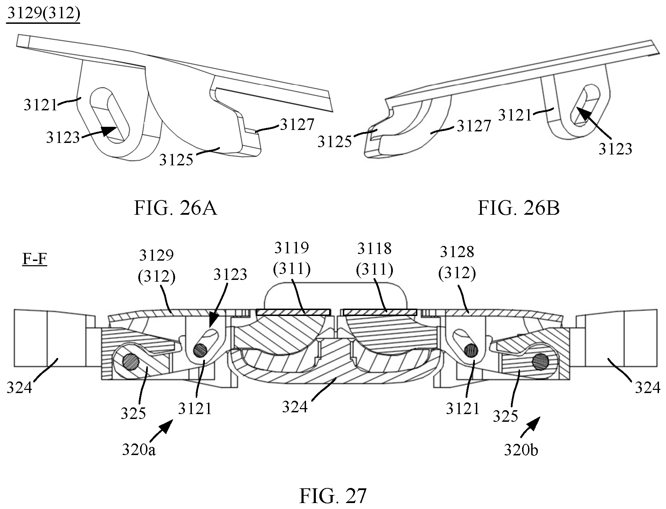

FIG. 26A and FIG. 26B are local diagrams of a structure of another second part 312 according to an embodiment of this application. FIG. 26A is a diagram of a structure of the second part 312 from a perspective, and FIG. 26B is a diagram of a structure of the second part 312 from another perspective. In some embodiments, a structure of the first sub-portion 3129 may be the same as a structure of the fourth sub-portion 3128. Alternatively, in some embodiments, a structure of the first sub-portion 3129 may be different from a structure of the fourth sub-portion 3128, provided that one end of the second part 312 of the first support plate 310a can be connected to the fourth connecting rod 325, the other end of the second part 312 of the first support plate 310a can be rotatably connected to the support 324, one end of the second part 312 of the second support plate 310b can be connected to the fourth connecting rod 325, and the other end of the second part 312 of the second support plate 310b can be rotatably connected to the support 324 of the second rotating portion 320b.

The following describes the second part 312 by using only the first sub-portion 3129 as an example.

With reference to FIG. 26A and FIG. 26B, the first sub-portion 3129 may include a first connecting plate 3121, and the first connecting plate 3121 has a fitting hole 3123. A distance between the support plane N and an end that is of the fitting hole 2123 and that is close to the main shaft 100 is less than a distance between the support plane N and an end that is of the fitting hole 2123 and that is away from the main shaft. Correspondingly, with reference to FIG. 25, the fourth connecting rod 325 further includes an avoidance slot 3257, a slot wall of the avoidance slot 3257 has a through hole 3254 that penetrates the slot wall, and an extension direction of the through hole 3254 is parallel to the first direction X. The first connecting plate 3121 of the first sub-portion 3129 is located in the avoidance slot 3257 of the fourth connecting rod 325, and a pin shaft penetrates the fitting hole 3123 of the first sub-portion 3129 and the through hole 3254 of the fourth connecting rod 325. When a pin shaft slides along a strip-shaped hole of the first sub-portion 3129, the first sub-portion 3129 rotates relative to the fourth connecting rod 325. Through the foregoing arrangement, the first sub-portion 3129 is slidably connected to the fourth connecting rod 325.

For example, the second part 312 may further include a second connecting plate 3125, and the second connecting plate 3125 further has a fifth arc-shaped sliding block 3127 that protrudes outward. Correspondingly, the support 324 may further include a fifth arc-shaped sliding slot 3243, and the fifth arc-shaped sliding block 3127 may be slidably connected to the fifth arc-shaped sliding slot 3243, so that the second part 312 and the support 324 can be rotatably connected in a connection manner with a virtual shaft.

It may be understood that the second part 312 and the fourth connecting rod 325 may be alternatively slidably connected in another manner, and the second part 312 and the support 324 may be alternatively rotatably connected in another manner. This is not limited in this application.

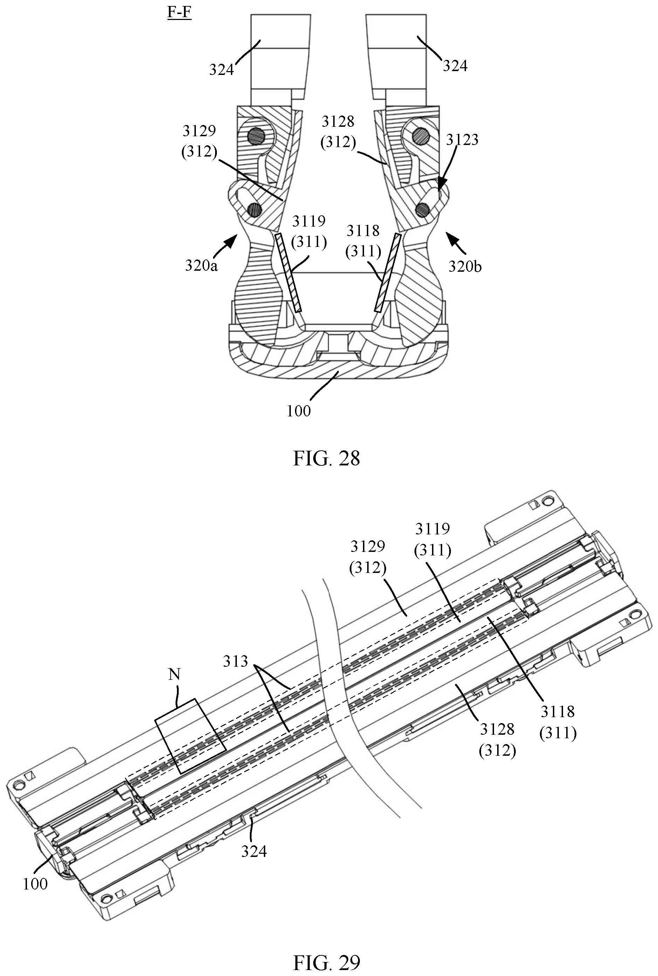

FIG. 27 is a sectional view of the rotating mechanism 10 in FIG. 25 in an unfolded state along an F-F section line; and FIG. 28 is a sectional view of the rotating mechanism 10 in FIG. 25 in a folded state along an F-F section line. With reference to FIG. 27 and FIG. 28, when the two hinge assemblies 300 rotate, and the support 324 drives the fourth connecting rod 325 to rotate relative to the main shaft 100, the fifth arc-shaped sliding block 3127 of the second part 312 slides along the fifth arc-shaped sliding slot 3243 of the support 324, so that the second part 312 rotates relative to the support 324, and the pin shaft connected to the fourth connecting rod 325 slides along the strip-shaped hole of the second part 312. When the two hinge assemblies 300 are in the unfolded state, the first sub-portion 3129, the second sub-portion 3119, the third sub-portion 3118, and the fourth sub-portion 3128 jointly form the support plane N, thereby improving flatness of the flexible display 30 in the unfolded state. When the two hinge assemblies 300 are in the folded state, a distance between the first end 3129a of the first sub-portion and the first end 3128a of the fourth sub-portion is greater than a distance between the second end 3129b of the first sub-portion and the second end 3128b of the fourth sub-portion in the second direction Y, a distance between the first end 3119a of the second sub-portion and the first end 3118a of the third sub-portion is less than a distance between the second end 3119b of the second sub-portion and the second end 3118b of the third sub-portion in the second direction Y, and the distance between the first end 3119a of the second sub-portion and the first end 3118a of the third sub-portion in the second direction Y increases, so that the flexible display 30 may be bent into a teardrop shape or an approximate teardrop shape, to avoid excessive extrusion on the flexible display 30, thereby reducing stress of the flexible display 30 and improving reliability of the flexible display 30.

In some embodiments, in the first support plate 310a, the first part 311 and the second part 312 may be two structures that are independent of each other, and the first part 311 and the second part 312 are disposed at an interval. For example, the first sub-portion 3129 and the second sub-portion 3119 may be two structures that are independent of each other. In the second support plate 310b, the first part 311 and the second part 312 may be two structures that are independent of each other, and the first part 311 and the second part 312 are disposed at an interval. For example, the third sub-portion 3118 and the fourth sub-portion 3128 may be two structures that are independent of each other.

FIG. 29 is a diagram of a structure of another support plate 310 according to an embodiment of this application. Alternatively, in some other embodiments, as shown in FIG. 29, the support plate 310 may further include a bendable portion 313, and the bendable portion 313 is connected between the first part 311 and the second part 312. For example, in the first support plate 310a, the bendable portion 313 may be connected between the first sub-portion 3129 and the second sub-portion 3119; and in the second support plate 310b, the bendable portion 313 may be connected between the third sub-portion 3118 and the fourth sub-portion 3128.

In some embodiments, structures of the first support plate 310a and the second support plate 310b may be the same. Certainly, in some other embodiments, structures of the first support plate 310a and the second support plate 310b may be different. This is not specifically limited in embodiments of this application. The following uses only the first support plate 310a as an example for description.

When the two hinge assemblies 300 are in the unfolded state, the bendable portion 313 is flattened. When the two hinge assemblies 300 are in the folded state, the bendable portion 313 is bent. Through the foregoing arrangement, the bendable portion 313 may fill a gap between the first part 311 and the second part 312. For example, in the first support plate 310a, the bendable portion 313 may fill a gap between the first sub-portion 3129 and the second sub-portion 3119. When the two hinge assemblies 300 are in the unfolded state, this helps further improve an effect of supporting the flexible display 30 by the support plate 310.

A center of the bendable portion 313 may be located on the rotation axis of the second connecting rod 322 relative to the first connecting rod 321. As described in the foregoing embodiment, the rotation axis of the second connecting rod 322 relative to the first connecting rod 321 is the second axis s2, that is, the center of the bendable portion 313 may be located on the second axis s2. When the second connecting rod 322 rotates relative to the first connecting rod 321, an included angle exists between the second connecting rod 322 and the first connecting rod 321, and the bendable portion 313 is bent under driving of the first connecting rod 321 and the second connecting rod 322. Certainly, in some other embodiments, there may be a specific distance between the center of the bendable portion 313 and the second axis s2, provided that the bendable portion 313 can be bent when the first connecting rod 321 and the second connecting rod 322 rotate. A position of the bendable portion 313 is not specifically limited in embodiments of this application.

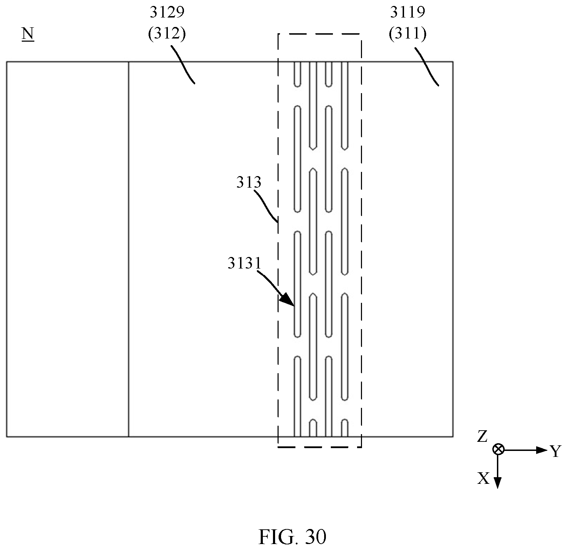

FIG. 30 is a local enlarged view of a position N of the support plate 310 in FIG. 29. As shown in FIG. 30, the bendable portion 313, the first sub-portion 3129, and the second sub-portion 3119 are of an integrated structure. For example, the integrated structure jointly formed by the bendable portion 313, the first sub-portion 3129, and the second sub-portion 3119 may be approximately of a flat plate structure. The foregoing arrangement helps improve structural reliability of the support plate 310.

In some embodiments, the bendable portion 313 may have a plurality of holes 3131. This helps reduce rigidity of the bendable portion 313, and reduce an elastic force of the bendable portion 313 on the flexible display 30 when the bendable portion 313 is bent, thereby improving a bending hand feeling of the support plate 310.

For example, the hole 3131 may penetrate the bendable portion 313, a shape of the hole 3131 may include a strip-shaped hole, and an extension direction of the hole 3131 may be parallel to the first direction X. The foregoing arrangement helps further reduce an elastic force of the bendable portion 313 on the flexible display 30 when the bendable portion 313 is bent, thereby further improving a bending hand feeling of the support plate 310. Certainly, in some other examples, a shape of the hole 3131 may alternatively be a circular hole, an elliptic hole, or the like. The shape of the hole 3131 is not specifically limited in embodiments of this application.

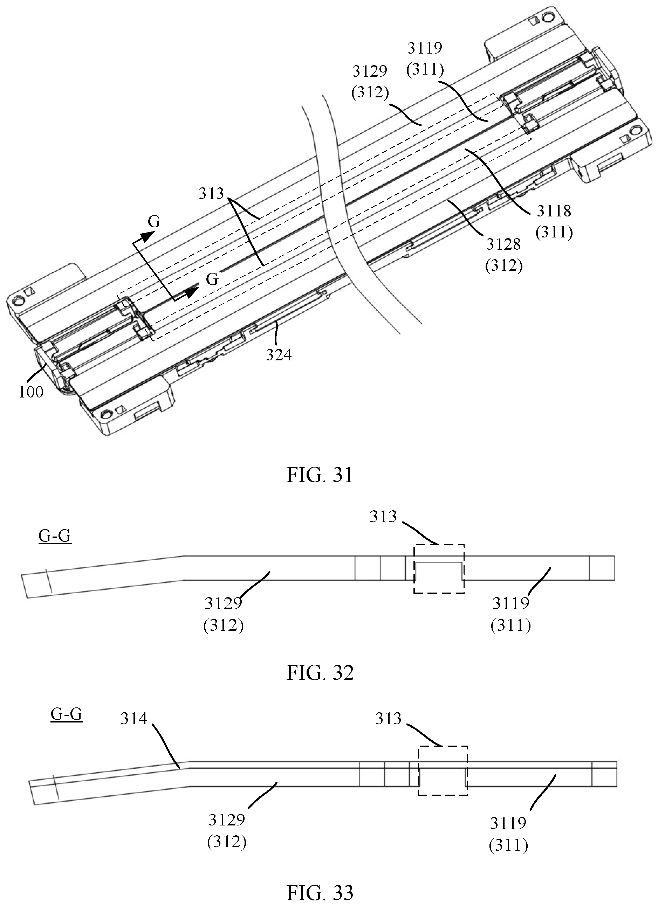

FIG. 31 is a diagram of a structure of another support plate 310 according to an embodiment of this application. FIG. 32 is a sectional view of the support plate 310 in FIG. 31 along a G-G section line. With reference to FIG. 31 and FIG. 32, in some other embodiments, a thickness of the bendable portion 313 may be less than a thickness of the first part 311, and the thickness of the bendable portion 313 may be less than a thickness of the second part 312. The first sub-portion 3129, the second sub-portion 3119, and the bendable portion 313 are of an integrated structure. For example, the integrated structure jointly formed by the first sub-portion 3129, the second sub-portion 3119, and the bendable portion 313 may be approximately of a flat plate structure. Thinning processing may be performed on the bendable portion 313, so that the thickness of the bendable portion 313 is less than the thickness of the first sub-portion 3129, and the thickness of the bendable portion 313 is further less than the thickness of the second sub-portion 3119. For example, surfaces on a side that is of the first sub-portion 3129, the second sub-portion 3119, and the bendable portion 313 and that is away from the rotating portion 320 are coplanar, and a surface on a side that is of the bendable portion 313 and that is close to the rotating portion 320 is recessed compared with surfaces of the first sub-portion 3129 and the second sub-portion 3119 that are close to the rotating portion 320. The foregoing arrangement helps reduce rigidity of the bendable portion 313, and reduce an elastic force of the bendable portion 313 on the flexible display 30 when the bendable portion 313 is bent, thereby improving a bending hand feeling of the support plate 310.

Further, surfaces on a side that is of the first sub-portion 3129, the second sub-portion 3119, and the bendable portion 313 and that is away from the rotating portion 320 are coplanar. This helps improve an effect of supporting the flexible display 30 by the support plate 310. Certainly, in some other embodiments, surfaces on a side that is of the first sub-portion 3129, the second sub-portion 3119, and the bendable portion 313 and that is close to the rotating portion 320 are coplanar, and a surface on a side that is of the bendable portion 313 and that is away from the rotating portion 320 is recessed compared with surfaces of the first sub-portion 3129 and the second sub-portion 3119 that are away from the rotating portion 320.

FIG. 33 is a sectional view of another support plate 310 in FIG. 31 along a G-G section line. With reference to FIG. 31 and FIG. 33, in some other embodiments, the support plate 310 may further include a flexible layer 314. The flexible layer 314 is connected to a same side of the first sub-portion 3129 and the second sub-portion 3119, and the flexible layer 314 located between the first sub-portion 3129 and the second sub-portion 3119 is the bendable portion 313. For example, the flexible layer 314 may be stacked with the first sub-portion 3129 and the second sub-portion 3119, and the flexible layer 314 may be located on a side that is of the first sub-portion 3129 and the second sub-portion 3119 and that is away from the rotating portion 320. The flexible layer 314 may be bonded to the first sub-portion 3129 and the second sub-portion 3119. A material of the flexible layer 314 may include, for example, a flexible thin film material such as Kevlar fiber cloth, polyethylene terephthalate (Polyethylene terephthalate, PET), or polyimide (Polyimide, PI), so that the flexible layer 314 can have a good bending effect. When the two hinge assemblies 300 are in the unfolded state, the flexible layer 314 located between the first sub-portion 3129 and the second sub-portion 3119 is flattened. This helps further improve an effect of supporting the flexible display 30 by the support plate 310. When the two hinge assemblies 300 are in the folded state, the flexible layer 314 located between the first sub-portion 3129 and the second sub-portion 3119 is bent.

Further, the flexible layer 314 may be located on a side that is of the first sub-portion 3129 and the second sub-portion 3119 and that is away from the rotating portion 320, to help improve an effect of supporting the flexible display 30 by the support plate 310. Certainly, in some other examples, the flexible layer 314 may be alternatively located on a side that is of the first sub-portion 3129 and the second sub-portion 3119 and that is close to the rotating portion 320. This is not specifically limited in embodiments of this application.

Further, the two swing rods 510 arranged in the second direction Y are referred to as a swing rod pair. A quantity of swing rod pairs is not limited in embodiments of this application. As shown in FIG. 10, using a rotating module 400 located in the middle as an example, the rotating module 400 may include four swing rod pairs, two swing rod pairs may be located on a side of the first connecting rod 321 in the first direction X, and the second structural portion 410 includes the two swing rod pairs, to implement a function of synchronous rotation of the two hinge assemblies 300. In addition, two swing rod pairs may be located on the other side of the first connecting rod 321 in the first direction X, and the first structural portion 420 includes the other two swing rod pairs, to implement a function of providing a damping force when the two hinge assemblies 300 rotate. As described in the foregoing embodiment, the main shaft 100 may further include a first fitting portion 100b and a second fitting portion 100c that are located on two sides of the support fitting portion 100a, the first fitting portion 100b is configured to be in fitting connection to the first structural portion 420, and the second fitting portion 100c is configured to be in fitting connection to the second structural portion 410.

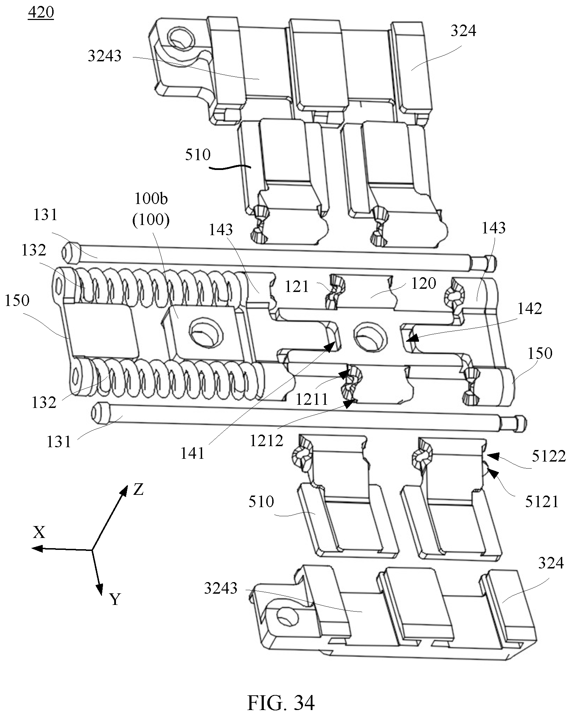

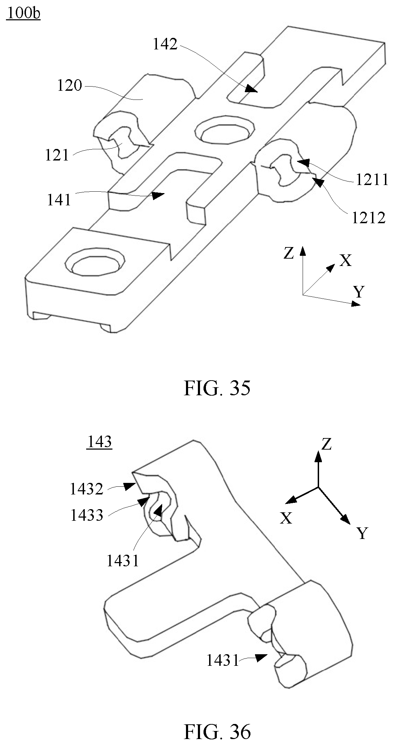

FIG. 34 is an exploded view of a structure of a first structural portion 420 according to an embodiment of this application. FIG. 35 is a diagram of a structure of a first fitting portion of a main shaft according to an embodiment of this application. The following describes structures of the first fitting portion 100b and the first structural portion 420 with reference to FIG. 34 and FIG. 35. As described in the foregoing embodiment, the main shaft 100 and the swing rod 510 may be rotatably connected through a pin shaft. In the first fitting portion 100b, a pin shaft connected between the main shaft 100 and the swing rod 510 may be referred to as a first rotating shaft 131. The first fitting portion 100b may include a first mounting portion 120, and the first mounting portion 120 has a main shaft connection hole 121 that runs through the first mounting portion 120.

Further, the first fitting portion 100b may further include a first sliding slot 141 and a second sliding slot 142 that are disposed at an interval in the first direction X, and the first mounting portion 120 is located between the first sliding slot 141 and the second sliding slot 142. Both the first sliding slot 141 and the second sliding slot 142 extend in the first direction X. Correspondingly, the first structural portion 420 may include two damping sliding blocks 143, where one damping sliding block 143 may be slidably connected to the first sliding slot 141, so that the one damping sliding block 143 can slide in the first direction X relative to the main shaft 100; and the other damping sliding block 143 may be slidably connected to the second sliding slot 142, so that the other damping sliding block 143 can slide in the first direction X relative to the main shaft 100.

FIG. 36 is a diagram of a structure of a damping sliding block 143 according to an embodiment of this application. As shown in FIG. 36, the damping sliding block 143 may further include two first through holes 1431 disposed in the second direction Y, and the first through holes 1431 extend in the first direction X. With reference to FIG. 34, one first rotating shaft 131 penetrates one first through hole 1431, so that the damping sliding block 143 may further slide in the first direction X relative to the first rotating shaft 131. In the damping sliding block 143, a surface that is adjacent to the first through hole 1431 and that faces the first mounting portion 120 includes a first convex portion 1432 and a first concave portion 1433 that are alternately disposed in a circumferential direction of the first through hole 1431. Correspondingly, in the swing rod 510, a surface that is adjacent to the swing rod connection hole 512 and that faces the damping sliding block 143 includes a second convex portion 5121 and a second concave portion 5122 that are alternately disposed in a circumferential direction of the swing rod connection hole 512. When the two hinge assemblies 300 are in the unfolded state or the folded state, the first concave portion 1433 is engaged with the second convex portion 5121, and the first convex portion 1432 is engaged with the second concave portion 5122. When the two hinge assemblies 300 rotate relative to the main shaft 100, the first convex portion 1432 is in contact with the second convex portion 5121.

Based on the foregoing structure, the first structural portion 420 may further include two first springs 132 disposed in the second direction Y. One first spring 132 may be sleeved on one first rotating shaft 131, one end of the first spring 132 abuts against one damping sliding block 143, and the other end of the first spring 132 is fastened to an end portion of the first rotating shaft 131 by using a circlip 150. When the two hinge assemblies 300 are in the unfolded state or the folded state, the first spring 132 is in a first compressed state. When the two hinge assemblies 300 rotate relative to the main shaft 100, the first spring 132 is in a second compressed state. A length of the first spring 132 in the second compressed state is less than a length of the first spring 132 in the first compressed state.

Through the foregoing arrangement, when the two hinge assemblies 300 are in the unfolded state or the folded state, the first concave portion 1433 is engaged with the second convex portion 5121, the first convex portion 1432 is engaged with the second concave portion 5122, the first spring 132 is in the first compressed state, an elastic recovery force of the first spring 132 has a damping effect, and the elastic recovery force can abut against the swing rod 510 in the first direction X, so that when no external force is exerted, the unfolded state and the folded state of the two hinge assemblies 300 can be maintained. When the two hinge assemblies 300 rotate, the first convex portion 1432 is in contact with the second convex portion 5121, so that the damping sliding block 143 moves along the first rotating shaft 131 in a direction away from the first mounting portion 120. In this way, the first spring 132 is further compressed and deformed, and the first spring 132 is in the second compressed state. In this case, an elastic recovery force of the first spring 132 has a damping effect.

Further, in the first mounting portion 120, a surface that is adjacent to the main shaft connection hole 121 and that faces the swing rod 510 includes a third convex portion 1211 and a third concave portion 1212 that are alternately disposed in a circumferential direction of the main shaft connection hole 121. When the two hinge assemblies 300 are in the unfolded state or the folded state, the first concave portion 1433 is engaged with the third convex portion 1211, and the first convex portion 1432 is engaged with the third concave portion 1212. When the two hinge assemblies 300 rotate relative to the main shaft 100, the first convex portion 1432 is in contact with the third convex portion 1211. Through the foregoing arrangement, when the two hinge assemblies 300 are in the unfolded state or the folded state, the unfolded state and the folded state of the two hinge assemblies 300 can be further maintained. When the two hinge assemblies 300 rotate relative to the main shaft 100, a movement distance of the damping sliding block 143 along the first rotating shaft 131 in a direction away from the first mounting portion 120 increases, and an elastic recovery force of the first spring 132 increases, that is, a damping force increases.

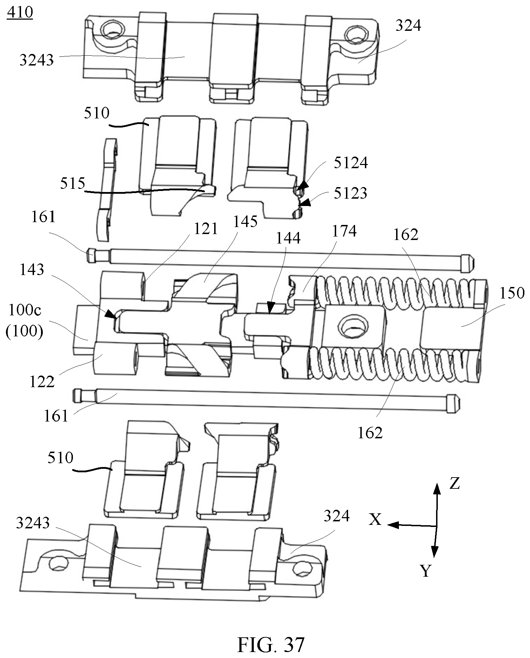

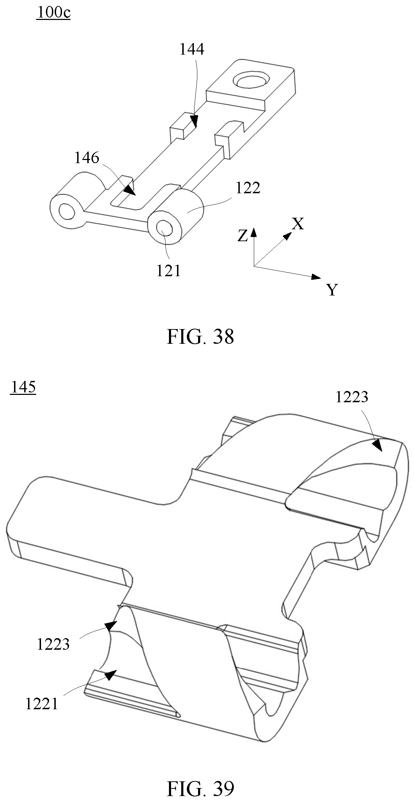

FIG. 37 is an exploded view of a structure of a second structural portion 410 according to an embodiment of this application. FIG. 38 is a diagram of a structure of a second fitting portion of a main shaft according to an embodiment of this application. The following describes structures of the second fitting portion 100c and the second structural portion 410 with reference to FIG. 37 and FIG. 38. As described in the foregoing embodiment, the main shaft 100 and the swing rod 510 may be rotatably connected through a pin shaft. In the second fitting portion 100c, a pin shaft connected between the main shaft 100 and the swing rod 510 may be referred to as a second rotating shaft 161. The second fitting portion 100c may include a second mounting portion 122, and the second mounting portion 122 has a main shaft connection hole 121 that runs through the second mounting portion 122.

Further, the second fitting portion 100c may further include a third sliding slot 146 and a fourth sliding slot 144 that are disposed at an interval in the first direction X, and the fourth sliding slot 144 is located on a side that is of the third sliding slot 146 and that is away from the second mounting portion 122. Both the fourth sliding slot 144 and the third sliding slot 146 extend in the first direction X. Correspondingly, the second structural portion 410 may include a first synchronization sliding block 145 and a second synchronization sliding block 174, where the first synchronization sliding block 145 may be slidably connected to the third sliding slot 146, so that the first synchronization sliding block 145 can slide in the first direction X relative to the main shaft 100; and the second synchronization sliding block 174 may be slidably connected to the fourth sliding slot 144, so that the second synchronization sliding block 174 can slide in the first direction X relative to the main shaft 100.

FIG. 39 is a diagram of a structure of a first synchronization sliding block 145 according to an embodiment of this application. As shown in FIG. 39, the first synchronization sliding block 145 further includes two third through holes 1221 disposed in the second direction Y, and the third through holes 1221 extend in the first direction X. With reference to FIG. 37, one second rotating shaft 161 penetrates one third through hole 1221, so that the first synchronization sliding block 145 may further slide in the first direction X relative to the second rotating shaft 161. In addition, a part of the first synchronization sliding block 145 that penetrates the second rotating shaft 161 is further located between the two swing rods 510 arranged in the first direction X. In the first synchronization sliding block 145, a surface that is adjacent to the first through hole 1431 and that faces the swing rod 510 includes a first spiral surface 1223. Correspondingly, in the swing rod 510, a surface that is adjacent to the swing rod connection hole 512 and that faces the first synchronization sliding block 145 includes a second spiral surface 515, and the second spiral surface 515 is engaged with the first spiral surface 1223.

Through the foregoing arrangement, when a hinge assembly 300 (for example, the first hinge assembly 300a) rotates, the swing rod 510 on the same side rotates relative to the main shaft 100, and the second spiral surface 515 rotates with the swing rod 510, so that the second spiral surface 515 pushes the first spiral surface 1223 of the first synchronization sliding block 145 on the same side, and the first synchronization sliding block 145 moves along the main shaft 100. The first spiral surface 1223 on the other side moves with the first synchronization sliding block 145, so that the first spiral surface 1223 pushes the second spiral surface 515 of the swing rod 510 on the other side, and then the swing rod 510 on the other side also rotates relative to the main shaft 100, and drives the other hinge assembly 300 (for example, the second hinge assembly 300b) to rotate. The "same side" and the "other side" may be understood as meaning that, relative to a central axis of the main shaft 100, one hinge assembly 300, one swing rod 510, and one first spiral surface 1223 of the first synchronization sliding block 145 are located on a same side, and the other hinge assembly 300, the other swing rod 510, and the other first spiral surface 1223 of the first synchronization sliding block 145 are located on the other side. In conclusion, through the foregoing arrangement, two swing rods 510 in one swing rod pair 510 can rotate synchronously relative to the main shaft 100, so that the two hinge assemblies 300 can rotate synchronously.

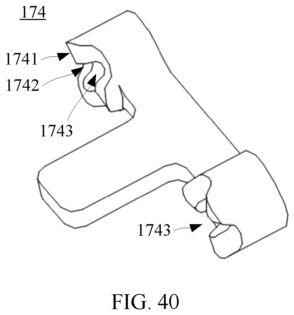

FIG. 40 is a diagram of a structure of a second synchronization sliding block 174 according to an embodiment of this application. As shown in FIG. 40, the second synchronization sliding block 174 further includes two fourth through holes 1743 disposed in the second direction Y, and the fourth through holes 1743 extend in the first direction X. With reference to FIG. 37, one second rotating shaft 161 penetrates one fourth through hole 1743, so that the second synchronization sliding block 174 may further slide in the first direction X relative to the second rotating shaft 161. In addition, a part of the second synchronization sliding block 174 that penetrates the second rotating shaft 161 is further located on a side that is of the swing rod 510 and that is away from the first synchronization sliding block 145. In the second synchronization sliding block 174, a surface that is adjacent to the fourth through hole 1743 and that faces the swing rod 510 includes a fourth convex portion 1741 and a fourth convex portion 1741 that are alternately disposed in a circumferential direction of the fourth through hole 1743. Correspondingly, in the swing rod 510, a surface that is adjacent to the swing rod connection hole 512 and that faces the second synchronization sliding block 174 includes a fifth convex portion 5123 and a fifth concave portion 5124 that are alternately disposed in a circumferential direction of the swing rod connection hole 512. When the two hinge assemblies 300 are in the unfolded state or the folded state, the fifth concave portion 5124 is engaged with the fourth convex portion 1741, and the fifth convex portion 5123 is engaged with the fourth concave portion 1742. When the two hinge assemblies 300 rotate relative to the main shaft 100, the fifth convex portion 5123 is in contact with the fourth convex portion 1741.

Based on the foregoing structure, the second structural portion 410 may further include two second springs 162 disposed in the second direction Y. One second spring 162 may be sleeved on one second rotating shaft 161, one end of the second spring 162 abuts against the second synchronization sliding block 174, and the other end of the second spring 162 is fastened to an end portion of the second rotating shaft 161 by using a circlip 150. When the two hinge assemblies 300 are in the unfolded state or the folded state, the second spring 162 is in a third compressed state. When the two hinge assemblies 300 rotate relative to the main shaft 100, the second spring 162 is in a fourth compressed state. A length of the second spring 162 in the fourth compressed state is less than a length of the second spring 162 in the third compressed state.

Through the foregoing arrangement, when the two hinge assemblies 300 are in the unfolded state or the folded state, the fifth concave portion 5124 is engaged with the fourth convex portion 1741, the fifth convex portion 5123 is engaged with the fourth concave portion 1742, the second spring 162 is in the third compressed state, an elastic recovery force of the second spring 162 has a damping effect, and the elastic recovery force can abut against the second synchronization sliding block 174 in the first direction X, so that when no external force is exerted, the unfolded state and the folded state of the two hinge assemblies 300 can be maintained. When the two hinge assemblies 300 rotate, the fifth convex portion 5123 is in contact with the fourth convex portion 1741, so that the second synchronization sliding block 174 moves along the second rotating shaft 161 in a direction away from the second mounting portion 122. In this way, the second spring 162 is further compressed and deformed, and the second spring 162 is in the fourth compressed state. In this case, an elastic recovery force of the second spring 162 has a damping effect.

In conclusion, while driving the two swing rods 510 to rotate synchronously, the second structural portion 410 can further provide a damping force when the two hinge assemblies 300 rotate.

The foregoing descriptions are merely specific implementations of this application. However, the protection scope of this application is not limited thereto. Any change or replacement readily figured out by a person skilled in the art within the technical scope disclosed in this application shall fall within the protection scope of this application. Therefore, the protection scope of this application shall be subject to the protection scope of the claims.

## Claims

1. A rotating mechanism, comprising:
a main shaft (100), wherein the main shaft (100) extends in a first direction (X);
two hinge assemblies (300), comprising a first hinge assembly (300a) and a second hinge assembly (300b), wherein the first hinge assembly (300a) is rotatably connected to the main shaft (100), the second hinge assembly (300b) is rotatably connected to the main shaft (100), and rotation axes of the two hinge assemblies (300) relative to the main shaft (100) are both parallel to the first direction (X) and do not coincide; and
a support plate (300), comprising four sub-portions, wherein the four sub-portions comprise a first sub-portion (3129), a second sub-portion (3119), a third sub-portion (3118), and a fourth sub-portion (3128), wherein
the first sub-portion (3129) is connected to the first hinge assembly (300a), the second sub-portion (3119) is connected to the first hinge assembly (300a), the third sub-portion (3118) is connected to the second hinge assembly (300b), and the fourth sub-portion (3128) is connected to the second hinge assembly (300b);
when the two hinge assemblies (300) are in an unfolded state: the first sub-portion (3129), the second sub-portion (3119), the third sub-portion (3118), and the fourth sub-portion (3128) are sequentially arranged in a second direction (Y); the first sub-portion (3129), the second sub-portion (3119), the third sub-portion (3118), and the fourth sub-portion (3128) jointly form a support plane (N); in the second direction (Y), a second end (3129b) of the first sub-portion, a first end (3129a) of the first sub-portion, a second end (3119b) of the second sub-portion, a first end (3119a) of the second sub-portion, a first end (3118a) of the third sub-portion, a second end (3118b) of the third sub-portion, a first end (3128a) of the fourth sub-portion, and a second end (3128b) of the fourth sub-portion are sequentially arranged; a distance between the first end (3119a) of the second sub-portion and the first end (3118a) of the third sub-portion in the second direction (Y) is a first distance (D1); and the second direction (Y) is perpendicular to the first direction (X);
in a process in which the rotating mechanism (10) switches from the unfolded state to a folded state, the first sub-portion (3129), the second sub-portion (3119), the third sub-portion (3118), and the fourth sub-portion (3128) rotate relative to the main shaft (100), and none of the four sub-portions of the support plate (300) is bent; and
when the two hinge assemblies (300) are in the folded state: a distance between the first end (3129a) of the first sub-portion and the first end (3128a) of the fourth sub-portion is greater than a distance between the second end (3129b) of the first sub-portion and the second end (3128b) of the fourth sub-portion in the second direction (Y), a distance between the first end (3119a) of the second sub-portion and the first end (3118a) of the third sub-portion is less than a distance between the second end (3119b) of the second sub-portion and the second end (3118b) of the third sub-portion in the second direction (Y), the distance between the first end (3119a) of the second sub-portion and the first end (3118a) of the third sub-portion in the second direction (Y) is a second distance (D2), and the second distance (D2) is greater than the first distance (D1).

2. The rotating mechanism according to claim 1, wherein
when the two hinge assemblies (300) are in the folded state, in a direction close to the main shaft (100), a distance between the first sub-portion (3129) and the fourth sub-portion (3128) in the second direction (Y) gradually increases, or a distance between the first sub-portion (3129) and the fourth sub-portion (3128) in the second direction (Y) first decreases and then increases.

3. The rotating mechanism according to claim 1, wherein
when the two hinge assemblies (300) are in the folded state, in a direction close to the main shaft (100), a distance between the second sub-portion (3119) and the third sub-portion (3118) in the second direction (Y) gradually decreases.

4. The rotating mechanism according to any one of claims 1 to 3, wherein the first hinge assembly (300a) comprises a first connecting rod (321), a second connecting rod (322), and a support (324), a first end (321a) of the first connecting rod is rotatably connected to the main shaft (100), a second end (321b) of the first connecting rod is rotatably connected to a first end (322a) of the second connecting rod, a second end (322b) of the second connecting rod is rotatably connected to the support (324), a rotation axis of the support (324) relative to the second connecting rod (322) is parallel to the first direction (X), a rotation axis of the second connecting rod (322) relative to the first connecting rod (321) is parallel to the first direction (X), and a rotation axis of the first connecting rod (321) relative to the main shaft (100) is parallel to the first direction (X); and
that the first sub-portion (3129) is connected to the first hinge assembly (300a), and the second sub-portion (3119) is connected to the first hinge assembly (300a) comprises:
the first sub-portion (3129) is connected to the second connecting rod (322), and the second sub-portion (3119) is connected to the first connecting rod (321).

5. The rotating mechanism according to claim 4, wherein the first sub-portion (3129) is fastened to the second connecting rod (322), and the second sub-portion (3119) is fastened to the first connecting rod (321).

6. The rotating mechanism according to claim 4 or 5, wherein that the first end (321a) of the first connecting rod is rotatably connected to the main shaft (100) comprises: the first end (321a) of the first connecting rod is rotatably connected to the main shaft (100) through a first arc-shaped sliding block (3212) and a first arc-shaped sliding slot (102); and
the first end (321a) of the first connecting rod comprises the first arc-shaped sliding block (3212), and the main shaft (100) comprises the first arc-shaped sliding slot (102); or the first end (321a) of the first connecting rod comprises the first arc-shaped sliding slot (102), and the main shaft (100) comprises the first arc-shaped sliding block (3212).

7. The rotating mechanism according to claim 6, wherein the first end (322a) of the second connecting rod is connected to the second end (321b) of the first connecting rod through a pin shaft, and that the second end (322b) of the second connecting rod is rotatably connected to the support (324) comprises: the second end (322b) of the second connecting rod is rotatably connected to the support (324) through a second arc-shaped sliding block (3223) and a second arc-shaped sliding slot (3241); and
the second end (322b) of the second connecting rod comprises the second arc-shaped sliding block (3223), and the support (324) comprises the second arc-shaped sliding slot (3241); or the second end (322b) of the second connecting rod comprises the second arc-shaped sliding slot (3241), and the support (324) comprises the second arc-shaped sliding block (3223).

8. The rotating mechanism according to any one of claims 4 to 7, wherein the first hinge assembly (300a) further comprises a third connecting rod (323), a first end (323a) of the third connecting rod is rotatably connected to the first connecting rod (321), and a second end (323b) of the third connecting rod is rotatably connected to the support (324);
the rotating mechanism (10) further comprises a back cover (101), the back cover (101) and the main shaft (100) are stacked in a third direction (Z), the back cover (101) comprises an outer surface (E), and the third direction (Z) is perpendicular to the first direction (X) and the second direction (Y);
a rotation axis of the third connecting rod (323) relative to the first connecting rod (321) is a first axis (s1), the first axis (s1) is parallel to the first direction (X), a rotation axis of the second connecting rod (322) relative to the first connecting rod (321) is a second axis (s2), and when the two hinge assemblies (300) are in the unfolded state, a distance between the second axis (s2) and a reference surface (F) in the third direction (Z) is greater than a distance between the first axis (s1) and the reference surface (F) in the third direction (Z), the reference surface (F) is parallel to the first direction (X) and the second direction (Y), and a farthest point on the outer surface (E) from the support plane (M) in the third direction (Z) intersects the reference surface (F); and
a rotation axis of the third connecting rod (323) relative to the support (324) is a third axis (s3), the third axis (s3) is parallel to the first direction (X), a rotation axis of the second connecting rod (322) relative to the support (324) is a fourth axis (s4), and when the two hinge assemblies (300) are in the unfolded state, a distance between the fourth axis (s4) and the reference surface (F) in the third direction (Z) is greater than a distance between the third axis (s3) and the reference surface (F) in the third direction (Z).

9. The rotating mechanism according to claim 8, wherein the second end (323b) of the third connecting rod is connected to the support (324) through a pin shaft, and the first end (323a) of the third connecting rod is rotatably connected to the first connecting rod (321) through a third arc-shaped sliding block (3232) and a third arc-shaped sliding slot (3214); and
the first end (323a) of the third connecting rod comprises the third arc-shaped sliding block (3232), and the first connecting rod (321) comprises the third arc-shaped sliding slot (3214); or the first end (323a) of the third connecting rod comprises the third arc-shaped sliding slot (3214), and the first connecting rod (321) comprises the third arc-shaped sliding block (3232).

10. The rotating mechanism according to any one of claims 4 to 9, wherein the first hinge assembly (300a) further comprises a fourth connecting rod (325), a first end (325a) of the fourth connecting rod is rotatably connected to the main shaft (100), a second end (325b) of the fourth connecting rod is rotatably connected to the support (324), and both a rotation axis of the support (324) relative to the fourth connecting rod (325) and a rotation axis of the fourth connecting rod (325) relative to the main shaft (100) are parallel to the first direction (X).

11. The rotating mechanism according to claim 10, wherein the second end (325b) of the fourth connecting rod is connected to the support (324) through a pin shaft, and that the first end (325a) of the fourth connecting rod is rotatably connected to the main shaft (100) comprises: the first end (325a) of the fourth connecting rod is rotatably connected to the main shaft (100) through a fourth arc-shaped sliding block (3252) and a fourth arc-shaped sliding slot (103); and
the first end (325a) of the fourth connecting rod comprises the fourth arc-shaped sliding block (3252), and the main shaft (100) further comprises the fourth arc-shaped sliding slot (103); or the first end (325a) of the fourth connecting rod comprises the fourth arc-shaped sliding slot (103), and the main shaft (100) further comprises the fourth arc-shaped sliding block (3252).

12. The rotating mechanism according to any one of claims 1 to 11, wherein the first hinge assembly (300a) further comprises a swing rod (510), a first end (510a) of the swing rod is rotatably connected to the main shaft (100), a rotation axis of the swing rod (510) relative to the main shaft (100) is parallel to the first direction (X), a second end (510b) of the swing rod is slidably connected to the support (324), and a sliding direction of the swing rod (510) relative to the support (324) is not parallel to an extension direction of the support (324); and
when the two hinge assemblies (300) rotate from the unfolded state to the folded state, the support (324) slides relative to the swing rod (510) in a direction away from the main shaft (100); and when the two hinge assemblies (300) rotate from the folded state to the unfolded state, the support (324) slides relative to the swing rod (510) in a direction close to the main shaft (100).

13. The rotating mechanism according to claim 12, wherein the first end (510a) of the swing rod comprises a swing rod (510) sliding block, the second end (510b) of the swing rod is rotatably connected to the main shaft (100) through a pin shaft, the support (324) comprises a support (324) sliding slot, and the swing rod (510) sliding block is slidably connected to the support (324) sliding slot.

14. The rotating mechanism according to any one of claims 1 to 13, wherein
the support plate (300) further comprises a bendable portion (313), and the bendable portion (313) is connected between the second sub-portion (3119) and the first sub-portion (3129); and
when the two hinge assemblies (300) are in the unfolded state, the bendable portion (313) is flattened; and when the two hinge assemblies (300) are in the folded state, the bendable portion (313) is bent, and a bending angle is formed between the first sub-portion (3129) and the second sub-portion (3119).

15. The rotating mechanism according to claim 14, wherein the bendable portion (313), the second sub-portion (3119), and the first sub-portion (3129) are of an integrated structure.

16. The rotating mechanism according to claim 15, wherein the bendable portion (313) has a plurality of holes.

17. The rotating mechanism according to claim 15, wherein a thickness of the bendable portion (313) is less than a thickness of the first sub-portion (3129), and the thickness of the bendable portion (313) is less than a thickness of the second sub-portion (3119).

18. The rotating mechanism according to claim 14, wherein the support plate (300) further comprises a flexible layer (314), the flexible layer (314) is connected to a same side of the second sub-portion (3119) and the first sub-portion (3129), and the flexible layer (314) located between the second sub-portion (3119) and the first sub-portion (3129) is the bendable portion (313).

19. The rotating mechanism according to any one of claims 1 to 18, wherein in a direction perpendicular to the support plane (N), the first sub-portion (3129) and the main shaft (100) at least partially overlap, and the second sub-portion (3119) and the main shaft (100) at least partially overlap.

20. A foldable electronic device, comprising a flexible display (30), a first mechanical part (21), a second mechanical part (22), and the rotating mechanism (10) according to any one of claims 1 to 19, wherein
the first mechanical part (21) and the second mechanical part (22) are connected to two sides of the rotating mechanism (10), and the flexible display (30) is located on a same side of the first mechanical part (21) and the second mechanical part (22), and is connected to the first mechanical part (21) and the second mechanical part (22);
when the foldable electronic device is in an unfolded state, a support plane (N) of the rotating mechanism (10) is used to support the flexible display (30); and
when the foldable electronic device is in a folded state, a first sub-portion (3129) of the rotating mechanism (10), a second sub-portion (3119) of the rotating mechanism (10), a third sub-portion (3118) of the rotating mechanism (10), a fourth sub-portion (3128) of the rotating mechanism (10), and a main shaft (100) of the rotating mechanism (10) jointly enclose screen accommodating space (M), and a part of the flexible display (30) is located in the screen accommodating space (M).

21. The foldable electronic device according to claim 20, wherein at least one of the first sub-portion (3129), the second sub-portion (3119), the third sub-portion (3118), and the fourth sub-portion (3128) is connected to the flexible display (30).
